(19) Europäisches Patentamt
European Patent Office
Office européen des brevets

(11) EP 2 741 595 B1

(12) # EUROPEAN PATENT SPECIFICATION

(45) Date of publication and mention of the grant of the patent:
**30.05.2018 Bulletin 2018/22**

(21) Application number: **12817221.0**

(22) Date of filing: **20.07.2012**

(51) Int Cl.:
***H05K 9/00*** ***(2006.01)*** ***B32B 15/08*** ***(2006.01)***
***H01Q 17/00*** ***(2006.01)***

(86) International application number:
**PCT/JP2012/068516**

(87) International publication number:
**WO 2013/015226 (31.01.2013 Gazette 2013/05)**

(54) **ELECTROMAGNETIC WAVE ABSORPTION FILM HAVING HIGH HEAT DISSIPATION PROPERTIES**

FOLIE ZUR ABSORPTION ELEKTROMAGNETISCHER WELLEN MIT HOHEN WÄRMEABLEITUNGSEIGENSCHAFTEN

FILM ABSORBANT POUR ONDES ÉLECTROMAGNÉTIQUES AYANT DES PROPRIÉTÉS ÉLEVÉES DE DISSIPATION THERMIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.07.2011 JP 2011163755**
**28.07.2011 JP 2011166020**

(43) Date of publication of application:
**11.06.2014 Bulletin 2014/24**

(73) Proprietor: **Kagawa, Seiji**
**Saitama 343-0807 (JP)**

(72) Inventor: **Kagawa, Seiji**
**Saitama 343-0807 (JP)**

(74) Representative: **Schwabe - Sandmair - Marx Patentanwälte Rechtsanwalt Partnerschaft mbB**
**Joseph-Wild-Straße 20**
**81829 München (DE)**

(56) References cited:
**WO-A1-2010/093027**
**JP-A- 2005 327 853**
**JP-A- 2006 114 877**
**JP-A- 2009 059 972**
**US-A1- 2005 276 978**
**US-A1- 2009 159 328**
**US-A1- 2010 188 833**
**US-A1- 2011 008 580**

EP 2 741 595 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention relates to an electromagnetic-wave-absorbing film having high electromagnetic wave absorbability as well as high thermal dissipation.

BACKGROUND OF THE INVENTION

Electromagnetic-wave-absorbing sheets for preventing the leakage and intrusion of electromagnetic waves are used in communications apparatuses such as cell phones, smartphones, wireless LAN, etc., and electronic apparatuses such as computers, etc. Electromagnetic-wave-absorbing sheets now widely used are constituted by metal sheets or nets, and those having metal films vapor-deposited on plastic sheets have recently been proposed. For example, JP 9-148782 A proposes an electromagnetic-wave-absorbing sheet comprising a plastic film, and first and second aluminum films vapor-deposited on both sides thereof, the first vapor-deposited aluminum film being etched to a non-conductive linear pattern, and the second vapor-deposited aluminum film being etched to a conductive network pattern. However, because the electromagnetic-wave-absorbing sheet of JP 9-148782 A has regular linear and network patterns, it fails to efficiently absorb electromagnetic waves in a wide frequency range, and suffers large anisotropy in electromagnetic wave absorbability.

JP 11-40980 A proposes an electromagnetic wave shield having a copper layer and a nickel layer vapor-deposited in this order on a surface of a plastic film. However, the electromagnetic wave shield of JP 11-40980 A has insufficient electromagnetic wave absorbability with large anisotropy.

WO 2010/093027 discloses an electromagnetic-wave-absorbing film comprising a plastic film, and a single- or multi-layer thin metal film formed on at least one surface thereof, the thin metal film being provided with large numbers of substantially parallel, intermittent, linear scratches with irregular widths and irregular intervals in plural directions. The electromagnetic-wave-absorbing film of WO 2010/093027 has high electromagnetic wave absorbability with reduced anisotropy, because of linear scratches formed in plural directions. However, to solve the increasingly severer problems of electromagnetic wave noises, electromagnetic-wave-absorbing films having higher electromagnetic wave absorbability are desired. Further, because of linear scratches with irregular widths and irregular intervals, the division of electromagnetic-wave-absorbing films to smaller sizes is likely to cause unevenness in electromagnetic wave noise absorbability.

As electronic apparatuses and electronic communications apparatuses such as note-type, personal computers, ultrabooks, cell phones, smartphones, etc. have become smaller, electronic parts such as CPU, LSI, etc. have been highly integrated, resulting in larger heat generation. Because these electronic apparatuses and electronic communications apparatuses are mobile, waterproofness is also required, so that heat dissipation has become increasingly difficult.

In such circumstances, JP 2006-135118 A proposes an electromagnetic-wave-absorbing, heat-dissipating sheet comprising an electromagnetic-wave-absorbing layer having thermal conductivity of 0.7 W/mK or more, and a far-infrared-emitting layer formed directly or via at least one other layer on a surface of the electromagnetic-wave-absorbing layer. The electromagnetic-wave-absorbing layer is formed by an insulating polymer of silicone, acrylic rubbers, ethylene propylene rubbers, fluororubbers, chlorinated polyethylene, etc., in which powder of soft-magnetic metals such as carbonyl iron, electrolytic iron, Fe-Cr alloys, Fe-Si alloys, Fe-Ni alloys, Fe-Co alloys, Fe-Al-Si alloys, Fe-Cr-Si alloys, Fe-Cr-Al alloys, Fe-Si-Ni alloys, Fe-Si-Cr-Ni alloys, etc. is uniformly dispersed. The far-infrared-emitting layer is formed by a silicone resin, etc., in which far-infrared-emitting oxide ceramics such as silicon oxide, aluminum oxide, cordierite, etc. are dispersed.

However, the electromagnetic-wave-absorbing, heat-dissipating sheet of JP 2006-135118 A, in which both of the electromagnetic-wave-absorbing layer and the far-infrared-emitting layer are resin-based, cannot be sufficiently thin. In Example 1, for example, the electromagnetic-wave-absorbing layer is as thick as 0.1 mm, and the far-infrared-emitting layer is as thick as 80 $\mu$m.

Recently, graphite sheets having higher thermal conductivity than those of aluminum and copper have become used as thermal diffusion sheets. For example, Graphinity of Kaneka Corporation is as thick as 25-40 $\mu$m at thermal conductivity of 1500 W/mK. However, graphite sheets are disadvantageously expensive.

Document US 2011/0008580 A1 discloses an electromagnetic-wave-absorbing film comprising a plastic film and a single- or multi-layer thin metal film formed on at least one surface of the plastic film. Said thin metal film is provided with large numbers of substantially parallel, intermittent, linear scratches with irregular widths and irregular intervals in plural directions, wherein 90 % or more of the widths is more preferably in a range of 1 - 100 $\mu$m and the average width is more preferably 1-20 $\mu$m, and wherein the intervals are most preferably in the range of 0.1 - 100 $\mu$m and the average interval is preferably 1 - 100 $\mu$m.

Document US 2005/0276978 relates to a wear resistant EMI shield including a metallic film or multiple metallic films and a carbon-nanotube coating formed on the metallic film or multiple metallic films. The wear resistant EMI shield may apply to various substrate surfaces.

OBJECT OF THE INVENTION

Accordingly, an object of the present invention is to provide a thin electromagnetic-wave-absorbing film having good absorbability to electromagnetic waves having various frequencies, together with high thermal diffusion (thermal dissipation), which can be produced at low cost.

DISCLOSURE OF THE INVENTION

As a result of intensive research in view of the above object, the inventor has found that the formation of a thin carbon nanotube layer on a thin-metal-film-side surface of an electromagnetic-wave-absorbing film comprising a thin metal film formed on a plastic film, the thin metal film being provided with large numbers of substantially parallel, intermittent, linear scratches with irregular widths and irregular intervals in plural directions, improves (a) electromagnetic wave absorbability with little unevenness even when divided to small pieces, and (b) thermal diffusion (thermal dissipation). The present invention has been found based on such finding.

Thus, the electromagnetic-wave-absorbing film of the present invention having high thermal dissipation comprises a plastic film, and a single- or multi-layer thin metal film formed on at least one surface of the plastic film; the thin metal film being provided with large numbers of substantially parallel, intermittent, linear scratches with irregular widths and irregular intervals in plural directions, and coated with a thin carbon nanotube layer; the linear scratches having widths in a range of 0.1-100 μm for 90% or more and 1-50 μm on average, and transverse intervals in a range of 1-500 μm and 1-200 μm on average; and the carbon nanotube having average length of 2 μm or more.

The linear scratches are preferably oriented in two directions with a crossing angle of 30-90°.

The thin metal film is preferably made of at least one metal selected from the group consisting of aluminum, copper, silver, tin, nickel, cobalt, chromium and these alloys.

The thickness of the thin carbon nanotube layer is preferably 0.01-0.5 $g/m^2$ when expressed by the mass of carbon nanotube coated per a unit area.

The carbon nanotube is preferably multi-layer carbon nanotube. The carbon nanotube preferably has average length of 3 μm or more.

The thin carbon nanotube layer preferably contains a binder resin.

A plastic film is preferably heat-laminated on the thin carbon nanotube layer.

BRIEF DESCRIPTION OF THE DRAWINGS

Fig. 1(a) is a cross-sectional view showing an electromagnetic-wave-absorbing film according to one embodiment of the present invention.

Fig. 1(b) is a partial plan view showing the details of linear scratches in the electromagnetic-wave-absorbing film of Fig. 1(a).

Fig. 1(c) is a cross-sectional view (a thin carbon nanotube layer omitted) taken along the line A-A in Fig. 1(b).

Fig. 1(d) is an enlarged cross-sectional view showing a portion A' in Fig. 1(c).

Fig. 1(e) is a cross-sectional view showing an electromagnetic-wave-absorbing film according to another embodiment of the present invention.

Fig. 1(f) is an enlarged cross-sectional view showing a portion B (a thin carbon nanotube layer omitted) in Fig. 1(e).

Fig. 2(a) is a partial plan view showing the details of linear scratches in an electromagnetic-wave-absorbing film according to a further embodiment of the present invention.

Fig. 2(b) is a partial plan view showing the details of linear scratches in an electromagnetic-wave-absorbing film according to a still further embodiment of the present invention.

Fig. 2(c) is a partial plan view showing the details of linear scratches in an electromagnetic-wave-absorbing film according to a still further embodiment of the present invention.

Fig. 3(a) is a partial plan view showing the details of linear scratches and fine pores in an electromagnetic-wave-absorbing film according to a still further embodiment of the present invention.

Fig. 3(b) is a cross-sectional view (a thin carbon nanotube layer omitted) taken along the line C-C in Fig. 3(a).

Fig. 4 is a cross-sectional view showing an electromagnetic-wave-absorbing film according to a still further embodiment of the present invention.

Fig. 5(a) is a perspective view showing one example of apparatuses for forming linear scratches.

Fig. 5(b) is a plan view showing the apparatus of Fig. 5(a).

Fig. 5(c) is a cross-sectional view taken along the line D-D in Fig. 5(b).

Fig. 5(d) is a partial, enlarged plan view for explaining the principle of forming linear scratches inclined from the moving direction of a composite film.

Fig. 5(e) is a partial plan view showing the inclination angles of a pattern roll and a push roll from a composite film in the apparatus of Fig. 5(a).

Fig. 6 is a partial cross-sectional view showing another example of apparatuses for forming linear scratches.

Fig. 7 is a perspective view showing a further example of apparatuses for forming linear scratches.

Fig. 8 is a perspective view showing a still further example of apparatuses for forming linear scratches.

Fig. 9 is a perspective view showing a still further example of apparatuses for forming linear scratches.

Fig. 10(a) is a plan view showing a system for evaluating the electromagnetic wave absorbability of an electromagnetic-wave-absorbing film.

Fig. 10(b) is a partially cross-sectional front view showing a system for evaluating the electromagnetic wave absorbability of an electromagnetic-wave-absorbing film.

Fig. 11(a) is a plan view showing a sample and an acrylic support plate used for the evaluation of thermal diffusion (thermal dissipation).

Fig. 11(b) is a plan view showing a sample fixed to an acrylic support plate.

Fig. 11(c) is a cross-sectional view showing a sample fixed to an acrylic support plate.

Fig. 11(d) is a partial, enlarged cross-sectional view showing a sample.

Fig. 12 is a schematic view showing a method for evaluating the thermal diffusion (thermal dissipation) of a sample.

Fig. 13 is a plan view showing a method for measuring the thermal diffusion of a sample.

Fig. 14 is a graph showing the relation between a transmission attenuation power ratio Rtp and the frequency of an incident wave in the electromagnetic-wave-absorbing films of Example 1 and Comparative Example 1.

Fig. 15 is a graph showing the relation between a noise absorption ratio $P_{loss}/P_{in}$ and the frequency of an incident wave in the electromagnetic-wave-absorbing films of Example 1 and Comparative Example 1.

Fig. 16 is a graph showing the thermal diffusion of the electromagnetic-wave-absorbing film of Example 1.

Fig. 17 is a graph showing the thermal diffusion of the electromagnetic-wave-absorbing film of Comparative Example 1.

Fig. 18 is a graph showing the relation between a transmission attenuation power ratio Rtp and the frequency of an incident wave in the electromagnetic-wave-absorbing films of Example 2 and Comparative Example 2.

Fig. 19 is a graph showing the relation between a noise absorption ratio $P_{loss}/P_{in}$ and the frequency of an incident wave in the electromagnetic-wave-absorbing films of Example 2 and Comparative Example 2.

Fig. 20 is a graph showing the relation between a transmission attenuation power ratio Rtp and the frequency of an incident wave in the electromagnetic-wave-absorbing films of Examples 1 and 5.

Fig. 21 is a graph showing the relation between a noise absorption ratio $P_{loss}/P_{in}$ and the frequency of an incident wave in the electromagnetic-wave-absorbing films of Examples 1 and 5.

Fig. 22 is a graph showing the relation between a transmission attenuation power ratio Rtp and the frequency of an incident wave in the electromagnetic-wave-absorbing film of Example 6.

Fig. 23 is a graph showing the relation between a noise absorption ratio $P_{loss}/P_{in}$ and the frequency of an incident wave in the electromagnetic-wave-absorbing film of Example 6.

Fig. 24 is a graph showing the relation between a transmission attenuation power ratio Rtp and the frequency of an incident wave in the electromagnetic-wave-absorbing film of Comparative Example 3.

Fig. 25 is a graph showing the relation between a noise absorption ratio $P_{loss}/P_{in}$ and the frequency of an incident wave in the electromagnetic-wave-absorbing film of Comparative Example 3.

Fig. 26 is a graph showing the relation between a transmission attenuation power ratio Rtp and the frequency of an incident wave in the electromagnetic-wave-absorbing film of Comparative Example 4.

Fig. 27 is a graph showing the relation between a noise absorption ratio $P_{loss}/P_{in}$ and the frequency of an incident wave in the electromagnetic-wave-absorbing film of Comparative Example 4.

Fig. 28 is a graph showing the relation between a noise absorption ratio $P_{loss}/P_{in}$ and the frequency of an incident wave in the electromagnetic-wave-absorbing film of Example 8.

Fig. 29 is a graph showing the thermal diffusion of the electromagnetic-wave-absorbing film of Example 8.

Fig. 30 is a graph showing the relation between a noise absorption ratio $P_{loss}/P_{in}$ and the frequency of an incident wave in the electromagnetic-wave-absorbing film of Example 8 after six months.

Fig. 31 is a graph showing the relation between a noise absorption ratio $P_{loss}/P_{in}$ and the frequency of an incident wave in the electromagnetic-wave-absorbing film of Comparative Example 6.

Fig. 32 is a graph showing the relation between a noise absorption ratio $P_{loss}/P_{in}$ and the frequency of an incident wave in the electromagnetic-wave-absorbing film of Comparative Example 6 after six months.

Fig. 33 is a graph showing the relation between a transmission attenuation power ratio Rtp and the frequency of an incident wave in the electromagnetic-wave-absorbing film of Comparative Example 7.

Fig. 34 is a graph showing the relation between a noise absorption ratio $P_{loss}/P_{in}$ and the frequency of an incident wave in the electromagnetic-wave-absorbing film of Comparative Example 7.
Fig. 35 is a graph showing the relation between a noise absorption ratio $P_{loss}/P_{in}$ and the frequency of an incident wave in the electromagnetic-wave-absorbing film of Example 9.
Fig. 36 is a graph showing the thermal diffusion of the electromagnetic-wave-absorbing film of Example 9.
Fig. 37 is a graph showing the relation between a noise absorption ratio $P_{loss}/P_{in}$ and the frequency of an incident wave in the electromagnetic-wave-absorbing film of Comparative Example 8.
Fig. 38 is a graph showing the thermal diffusion of the electromagnetic-wave-absorbing film of Comparative Example 8.
Fig. 39 is a graph showing the relation between a noise absorption ratio $P_{loss}/P_{in}$ and the frequency of an incident wave in the electromagnetic-wave-absorbing film of Comparative Example 9.
Fig. 40 is a graph showing the thermal diffusion of the electromagnetic-wave-absorbing film of Comparative Example 9.
Fig. 41 is a graph showing the thermal diffusion of the electromagnetic-wave-absorbing film of Comparative Example 10.
Fig. 42 is a graph showing the thermal diffusion of the graphite sheet of Comparative Example 11.

## DESCRIPTION OF THE PREFERRED EMBODIMENTS

The embodiments of the present invention will be explained referring to the attached drawings, and it should be noted that explanation concerning one embodiment is applicable to other embodiments unless otherwise mentioned. Also, the following explanation is not restrictive, and various modifications may be made within the scope of the present invention.

### [1] electromagnetic-wave-absorbing film

As shown in Fig. 1(a), the electromagnetic-wave-absorbing film 1 of the present invention has a structure comprising a single- or multi-layer thin metal film 11 and a thin carbon nanotube layer 14 formed in this order on at least one surface of a plastic film 10. Figs. 1(a)-1(d) show an example of large numbers of substantially parallel, intermittent linear scratches 12 formed in two directions in a thin metal film 11 formed on a plastic film 10.

#### (1) Plastic film

Resins forming the plastic film 10 are not particularly restrictive as long as they have sufficient strength, flexibility and workability in addition to insulation, and they may be, for instance, polyesters (polyethylene terephthalate, etc.), polyarylene sulfide (polyphenylene sulfide, etc.), polyamides, polyimides, polyamideimides, polyether sulfone, polyetheretherketone, polycarbonates, acrylic resins, polystyrenes, polyolefins (polyethylene, polypropylene, etc.), etc. From the aspect of strength and cost, polyethylene terephthalate is preferable. The thickness of the plastic film 10 may be about 10-100 μm.

#### (2) Thin metal film

Metals forming the thin metal film 11 are not particularly restrictive as long as they have conductivity, and they are preferably aluminum, copper, silver, tin, nickel, cobalt, chromium and their alloys, particularly aluminum, copper, nickel and their alloys, from the aspect of corrosion resistance and cost. The thickness of the thin metal film is preferably 0.01 μm or more. Though not restrictive, the upper limit of the thickness may be practically about 10 μm. Of course, the thin metal film may be thicker than 10 μm, with substantially no change in the absorbability of high-frequency electromagnetic waves. The thickness of the thin metal film is more preferably 0.01-5 μm, most preferably 0.01-1 μm. The thin metal film 11 can be formed by vapor deposition methods (physical vapor deposition methods such as a vacuum vapor deposition method, a sputtering method and an ion plating method, or chemical vapor deposition methods such as a plasma CVD method, a thermal CVD method and a photo CVD method), plating methods, or foil-bonding methods.

When the thin metal film 11 is a single layer, the thin metal film 11 is preferably made of aluminum or nickel from the aspect of conductivity, corrosion resistance and cost. When the thin metal film 11 has a multi-layer structure, one layer may be formed by a non-magnetic metal, while the other layer may be formed by a magnetic metal. The non-magnetic metals include aluminum, copper, silver, tin and these alloys, and the magnetic metals include nickel, cobalt, chromium and these alloys. The thickness of the magnetic thin metal film is preferably 0.01 μm or more, and the thickness of the non-magnetic thin metal film is preferably 0.1 μm or more. Though not restrictive, the upper limits of their thickness may be practically about 10 μm. More preferably, the thickness of the magnetic thin metal film is 0.01-5 μm, and the

thickness of the non-magnetic thin metal film is 0.1-5 μm. Figs. 1(e) and 1(f) show two-layer, thin metal films 11a, 11b formed on a plastic film 10.

(3) Linear scratches

As shown in Figs. 1(b) and 1(c), the thin metal film 11 is provided with large numbers of substantially parallel, intermittent, linear scratches 12a, 12b with irregular widths and irregular intervals in two directions. The depth of the linear scratches 12 is exaggerated in Fig. 1(c) for the purpose of explanation. The linear scratches 12 oriented in two directions have various widths W and intervals I. As described later, because the linear scratches 12 are formed by sliding contact with a pattern roll having fine, hard particles (fine diamond particles) randomly attached to the surface, there are no differences in the intervals I of linear scratches between a transverse direction and a longitudinal direction. Though explanation will be made on transverse intervals I below, such explanation is applicable to longitudinal intervals as it is. The widths W of the linear scratches 12 are measured at a height corresponding to the surface S of the thin metal film 11 before forming linear scratches, and the intervals I of the linear scratches 12 are measured at a height corresponding to the surface S of the thin metal film 11 before forming linear scratches.
Because the linear scratches 12 have various widths W and intervals I, the electromagnetic-wave-absorbing film 1 of the present invention can efficiently absorb electromagnetic waves in a wide frequency range.
90% or more of the widths W of the linear scratches 12 are preferably in a range of 0.1-100 μm, more preferably in a range of 0.1-50 μm, most preferably in a range of 0.5-20 μm. The average width Wav of the linear scratches 12 is preferably 1-50 μm, more preferably 1-10 μm, most preferably 1-5 μm.
The transverse intervals I of the linear scratches 12 are preferably in a range of 1-500 μm, more preferably in a range of 1-100 μm, most preferably in a range of 1-50 μm, particularly in a range of 1-30 μm. The average transverse interval Iav of the linear scratches 12 is preferably 1-200 μm, more preferably 5-50 μm, most preferably 5-30 μm.
Because the lengths L of the linear scratches 12 are determined by sliding conditions (mainly relative peripheral speeds of a roll and a film, and the angle of the composite film wound around the roll), they are substantially the same (substantially equal to the average length) unless the sliding conditions are changed. The lengths of the linear scratches 12 may be practically about 1-100 mm, preferably 2-10 mm, though not particularly restrictive.
The acute crossing angle (hereinafter referred to simply as "crossing angle" unless otherwise mentioned) θs of the linear scratches 12a, 12b are preferably 10-90°, more preferably 30-90°. With sliding conditions (sliding direction, peripheral speed ratio, etc.) between the composite film and the pattern roll adjusted, linear scratches 12 with various crossing angles θs can be formed as shown in Figs. 2(a) to 2(c). Fig. 2(a) shows an example of linear scratches 12a, 12b, 12c in three directions, Fig. 2(b) shows an example of linear scratches 12a, 12b, 12c, 12d in four directions, and Fig. 2 (c) shows an example of perpendicularly crossing linear scratches 12a', 12b'.

(4) Fine pores

As shown in Figs. 3(a) and 3(b), the thin metal film 11 may be provided with large numbers of fine penetrating pores 13 at random in addition to the linear scratches 12. The fine pores 13 can be formed by pressing a roll having fine, hard particles on the surface to the thin metal film 11. As shown in Fig. 3(b), the opening diameters D of the fine pores 13 are determined at a height corresponding to the surface S of the thin metal film 11 before forming the linear scratches. 90% or more of the opening diameters D of the fine pores 13 are preferably in a range of 0.1-1000 μm, more preferably in a range of 0.1-500 μm. The average opening diameter Dav of the fine pores 13 is preferably in a range of 0.5-100 μm, more preferably in a range of 1-50 μm.

(5) Thin carbon nanotube layer

A thin carbon nanotube layer 14 is formed on the thin metal film 11 having linear scratches 12. The carbon nanotube may have a single-layer structure or a multi-layer structure. Multi-layer carbon nanotube is preferable, because it has a diameter of about 10 nm to several tens of nm, is easily formed into a uniform, thin layer without aggregation, and has excellent conductivity.
Carbon nanotube coated on the thin metal film 11 having linear scratches 12 should have an average length of 2 μm or more. The carbon nanotube intrudes into the linear scratches 12 on the thin metal film 11, resulting in electric conduction not only between the carbon nanotube and the thin metal film 11, but also between the carbon nanotubes themselves. Accordingly, too short carbon nanotube provides insufficient electric conduction, resulting in low electromagnetic wave absorbability and low thermal diffusion (thermal dissipation). The average length of carbon nanotube can be determined by image-analyzing a photomicrograph of a glass plate coated with a dilute carbon nanotube dispersion. The upper limit of the average length of carbon nanotube is not particularly restricted, but may be determined taking into consideration the dispersibility of carbon nanotube.

Because the carbon nanotube is formed in the presence of a metal catalyst such as Co, Ni, Fe, etc., it contains an unseparated catalyst. It has been found that particularly when the thin metal film 11 is made of aluminum, the aluminum is corroded by a reaction with the remaining catalyst. Accordingly, when the thin aluminum film 11 is coated with a catalyst-remaining carbon nanotube dispersion, the electromagnetic wave absorbability and the thermal diffusion (thermal dissipation) are deteriorated with time. To prevent this, the metal catalyst is preferably removed from the carbon nanotube. The removal of the metal catalyst can be conducted by adding an acid such as nitric acid, hydrochloric acid, etc. to an aqueous carbon nanotube dispersion.

The thickness (coated amount) of the thin carbon nanotube layer 14 is preferably 0.01-0.5 g/$m^2$ when expressed by the mass of carbon nanotube. When the thin carbon nanotube layer 14 is thinner than 0.01 g/$m^2$, a sufficient effect of improving electromagnetic wave absorbability with more uniformity cannot be obtained. On the other hand, when it is thicker than 0.5 g/$m^2$, it is difficult to prevent the aggregation of carbon nanotube, resulting in an uneven thin carbon nanotube layer 14. The thickness of the thin carbon nanotube layer 14 is more preferably 0.02-0.2 g/$m^2$, most preferably 0.04-0.1 g/$m^2$, when expressed by the mass of carbon nanotube.

To prevent the detachment of carbon nanotube, the thin carbon nanotube layer preferably contains a binder resin. The binder resins include celluloses such as ethyl cellulose; acrylic resins; styrene polymers such as polystyrene, styrene-butadiene random copolymers and styrene-butadiene-styrene block copolymers; polyvinyl pyrrolidone; polyvinyl alcohol; polyethylene glycol; polypropylene glycol; polyvinyl butyral; polypropylene carbonate; polyvinyl chloride; etc. These binder resins may be used alone or in combination. Though not restrictive, the amount of the binder resin contained is preferably, for example, in a range of 0.01-10 g/$m^2$. In addition to the binder resin, a known dispersant may be contained.

Because both linear scratches 12 and carbon nanotube have random sizes and distributions, they microscopically form an uneven electromagnetic-wave-absorbing structure, but the existence of numerous, different electromagnetic-wave-absorbing structures macroscopically exhibits uniform electromagnetic wave absorbability.

(6) Protective layer

To protect the thin carbon nanotube layer 14, as shown in Fig. 4, the thin carbon nanotube layer 14 is preferably covered with a protective plastic layer 15. A plastic film for the protective plastic layer 15 may be the same as the base plastic film 10. The thickness of the protective layer 15 is preferably about 10-100 μm.

[2] Production method of electromagnetic-wave-absorbing film

(1) Formation of linear scratches

Figs. 5(a) to 5(e) show one example of apparatuses for forming linear scratches in two directions. This apparatus comprises (a) a reel 21 from which a thin metal film-plastic composite film 100 is wound off, (b) a first pattern roll 2a arranged in a different direction from the transverse direction of the composite film 100 on the side of the thin metal film 11, (c) a first push roll 3a arranged upstream of the first pattern roll 2a on the opposite side to the thin metal film 11, (d) a second pattern roll 2b arranged in an opposite direction to the first pattern roll 2a with respect to the transverse direction of the composite film 100 on the side of the thin metal film 11, (e) a second push roll 3b arranged downstream of the second pattern roll 2b on the opposite side to the thin metal film 11, (f) an electric-resistance-measuring means 4a arranged on the side of the thin metal film 11 between the first and second pattern rolls 2a, 2b, (g) an electric-resistance-measuring means 4b arranged downstream of the second pattern roll 2b on the side of the thin metal film 11, and (h) a reel 24, around which the linearly scratched, thin metal film-plastic composite film 1 is wound. In addition, pluralities of guide rolls 22, 23 are arranged at predetermined positions. Each pattern roll 2a, 2b is supported by a backup roll (for instance, rubber roll) 5a, 5b to prevent bending.

As shown in Fig. 5(c), because each push roll 3a, 3b comes into contact with the composite film 100 at a lower position than the position at which it is brought into sliding contact with each pattern roll 2a, 2b, the thin metal film 11 of the composite film 100 is pushed by each pattern roll 2a, 2b. By adjusting the longitudinal position of each push roll 3a, 3b with this condition met, the pressing power of each pattern roll 2a, 2b to the thin metal film 11 can be controlled, and the sliding distance in proportional to the center angle $\theta_1$ can also be controlled.

Fig. 5(d) shows the principle that linear scratches 12a are formed on the composite film 100 with inclination from the moving direction thereof. Because the pattern roll 2a is inclined from the moving direction of the composite film 100, the moving direction (rotation direction) *a* of fine, hard particles on the pattern roll 2a differs from the moving direction *b* of the composite film 100. After a fine, hard particle at a point A on the pattern roll 2a comes into contact with the thin metal film 11 to form a scratch B at an arbitrary time as shown by X, the fine, hard particle moves to a point A', and the scratch B moves to a point B', in a predetermined period of time. While the fine, hard particle moves from the point A to the point A', the scratch is continuously formed, resulting in a linear scratch 12a extending from the point B' to the point A'.

The directions and crossing angle θs of the first and second linear scratch groups 12A, 12B formed by the first and second pattern rolls 2a, 2b can be adjusted by changing the angle of each pattern roll 2a, 2b to the composite film 100, and/or the peripheral speed of each pattern roll 2a, 2b relative to the moving speed of the composite film 100. For instance, when the peripheral speed *a* of the pattern roll 2a relative to the moving speed *b* of the composite film 100 increases, the linear scratches 12a can be inclined 45° from the moving direction of the composite film 100 like a line C'D' as shown by Y in Fig. 5(d). Similarly, the peripheral speed *a* of the pattern roll 2a can be changed by changing the inclination angle $\theta_2$ of the pattern roll 2a to the transverse direction of the composite film 100. This is true of the pattern roll 2b. Accordingly, with both pattern rolls 2a, 2b adjusted, the directions of the linear scratches 12a, 12b can be changed as illustrated in Figs. 1(b) and 2(c).

Because each pattern roll 2a, 2b is inclined from the composite film 100, sliding with each pattern roll 2a, 2b provides the composite film 100 with a force in a transverse direction. Accordingly, to prevent the lateral movement of the composite film 100, the longitudinal position and/or angle of each push roll 3a, 3b to each pattern roll 2a, 2b are preferably adjusted. For instance, the proper adjustment of a crossing angle $\theta_3$ between the axis of the pattern roll 2a and the axis of the push roll 3a provides pressing power with such a transverse distribution as to cancel transverse force components, thereby preventing the lateral movement. The adjustment of a distance between the pattern roll 2a and the push roll 3a also contributes to the prevention of the lateral movement. To prevent the lateral movement and breakage of the composite film 100, the rotation directions of the first and second pattern rolls 2a, 2b inclined from the transverse direction of the composite film 100 are preferably the same as the moving direction of the composite film 100.

As shown in Fig. 5(b), each roll-shaped electric-resistance-measuring means 4a, 4b comprises a pair of electrodes 41, 41 via an insulating portion 40, to measure the electric resistance of the thin metal film 11 with linear scratches therebetween. Feedbacking the electric resistance measured by the electric-resistance-measuring means 4a, 4b, operation conditions such as the moving speed of the composite film 100, the rotation speeds and inclination angles $\theta_2$ of the pattern rolls 2a, 2b, the positions and inclination angles $\theta_3$ of the push rolls 3a, 3b, etc. are adjusted.

To increase the power of the pattern rolls 2a, 2b pressing the composite film 100, a third push roll 3c may be provided between the pattern rolls 2a, 2b as shown in Fig. 6. The third push roll 3c increases the sliding distance of the thin metal film 11 proportional to the center angle $\theta_1$, resulting in longer linear scratches 12a, 12b. The adjustment of the position and inclination angle of the third push roll 3c contributes to the prevention of the lateral movement of the composite film 100.

Fig. 7 shows one example of apparatuses for forming linear scratches oriented in three directions as shown in Fig. 2(a). This apparatus is different from the apparatus shown in Figs. 5(a) to 5(e) in that it comprises a third pattern roll 2c parallel to the transverse direction of the composite film 100 downstream of the second pattern roll 2b. Though the rotation direction of the third pattern roll 2c may be the same as or opposite to the moving direction of the composite film 100, it is preferably an opposite direction to form linear scratches efficiently. The third pattern roll 2c parallel to the transverse direction forms linear scratches 12c aligned with the moving direction of the composite film 100. Though the third push roll 30b is arranged upstream of the third pattern roll 2c, it may be on the downstream side. An electric-resistance-measuring roll 4c may be arranged downstream of the third pattern roll 2c. Not restricted to the depicted examples, the third pattern roll 2c may be arranged upstream of the first pattern roll 2a, or between the first and second pattern rolls 2a, 2b.

Fig. 8 shows one example of apparatuses for forming linear scratches oriented in four directions as shown in Fig. 2(b). This apparatus is different from the apparatus shown in Fig. 7, in that it comprises a fourth pattern roll 2d between the second pattern roll 2b and the third pattern roll 2c, and a fourth push roll 3d upstream of the fourth pattern roll 2d. With a slower rotation speed of the fourth pattern roll 2d, the direction (line E'F') of linear scratches 12a' can be made in parallel to the transverse direction of the composite film 100 as shown by Z in Fig. 5(d).

Fig. 9 shows another example of apparatuses for forming linear scratches oriented in two perpendicular directions as shown in Fig. 2(c). This apparatus is different from the apparatus shown in Figs. 5(a) to 5(e), in that the second pattern roll 32b is in parallel to the transverse direction of the composite film 100. Accordingly, only portions different from those shown in Figs. 5(a) to 5(e) will be explained. The rotation direction of the second pattern roll 32b may be the same as or opposite to the moving direction of the composite film 100. Also, the second push roll 33b may be upstream or downstream of the second pattern roll 32b. This apparatus makes the direction (line E'F') of linear scratches 12a' in alignment with the transverse direction of the composite film 100 as shown by Z in Fig. 5(d), suitable for forming linear scratches shown in Fig. 2(c).

Operation conditions determining not only the inclination angles and crossing angles of linear scratches but also their depths, widths, lengths and intervals are the moving speed of the composite film 100, the rotation speeds and inclination angles and pressing powers of the pattern rolls, etc. The moving speed of the composite film is preferably 5-200 m/minute, and the peripheral speed of the pattern roll is preferably 10-2,000 m/minute. The inclination angles $\theta_2$ of the pattern rolls are preferably 20-60°, particularly about 45°. The tension (in parallel to the pressing power) of the composite film 100 is preferably 0.05-5 kgf/cm width.

The pattern roll used in the apparatus for forming linear scratches is preferably a roll having fine particles with sharp edges and Mohs hardness of 5 or more on the surface, for instance, the diamond roll described in JP 2002-59487 A. Because the widths of linear scratches are determined by the sizes of fine particles, 90% or more of fine diamond particles have sizes preferably in a range of 1-1,000 μm, more preferably in a range of 10-200 μm. The fine diamond particles are attached to the roll surface preferably in an area ratio of 50% or more.

The thin metal film 11 having linear scratches 12 may be provided with large numbers of fine pores 13 by the method described in Japanese Patent 2063411. A roll per se for forming fine pores 13 may be the same as the roll for forming linear scratches. Fine pores 13 can be formed by causing the composite film 100 to pass between a roll having large numbers of fine particles with sharp edges and Mohs hardness of 5 or more on the surface like the roll for forming linear scratches and a roll having a smooth surface at the same peripheral speed.

(2) Formation of thin carbon nanotube layer

The thin metal film 11 having linear scratches 12, which is formed on at least one surface of the electromagnetic-wave-absorbing film 1, is coated with a carbon nanotube dispersion, and spontaneously dried to form a thin carbon nanotube layer 14. The carbon nanotube dispersion comprises (a) carbon nanotube and if necessary, a dispersant, or (b) carbon nanotube, a binder resin, and if necessary, a dispersant, in an organic solvent. The concentration of carbon nanotube in the dispersion is preferably 0.01-2% by mass. When the concentration of carbon nanotube is less than 0.1% by mass, a sufficient amount of carbon nanotube is not coated. On the other hand, when it is more than 2% by mass, carbon nanotube is likely aggregated in the dispersion, failing to form a uniform, thin carbon nanotube layer. The concentration of carbon nanotube is more preferably 0.01-1% by mass, most preferably 0.1-0.5% by mass.

When the binder resin is contained, its concentration in the carbon nanotube dispersion is preferably 0.1-10% by mass, more preferably 1-5% by mass, from the aspect of the viscosity of the dispersion and the uniform dispersibility of carbon nanotube.

Organic solvents used in the carbon nanotube dispersion include low-boiling-point solvents such as methanol, ethanol, isopropyl alcohol, benzene, toluene, methyl ethyl ketone, etc.; alkylene glycols such as ethylene glycol, propylene glycol, etc.; alkyl ethers of alkylene glycols such as propylene glycol monomethyl ether, dipropylene glycol monoethyl ether, etc.; alkyl ether acetates of alkylene glycols such as propylene glycol monoethyl ether acetate, dipropylene glycol monoethyl ether acetate, diethylene glycol monobutyl ether acetate, etc.; terpenes such as terpineol, etc.

To form the thin carbon nanotube layer 14 having a thickness of 0.01-0.5 g/m$^2$ when expressed by the mass of carbon nanotube, the amount of the carbon nanotube dispersion coated is determined depending on its concentration. Though not restrictive, the coating method of the carbon nanotube dispersion is preferably an inkjet printing method, etc. to form a uniform thin layer 14. The carbon nanotube dispersion need not be coated by one application, but may be coated by pluralities of application steps to form as uniform a thin carbon nanotube layer 14 as possible.

(3) Protective plastic layer

To protect the thin carbon nanotube layer 14, a protective plastic layer 15 formed by a plastic film is preferably heat-laminated. In the case of a PET film, the heat lamination temperature may be 110-150°C.

[3] Performance of electromagnetic-wave-absorbing film

(1) Evaluation of electromagnetic wave absorbability

(a) Transmission attenuation power ratio

Using a system shown in Figs. 10(a) and 10(b), which comprises a microstripline MSL (64.4 mm x 4.4 mm) of 50 Ω, an insulation substrate 120 supporting the microstripline MSL, a grounded electrode 121 attached to a lower surface of the insulation substrate 120, conductor pins 122, 122 connected to both edges of the microstripline MSL, a network analyzer NA, and coaxial cables 123, 123 for connecting the network analyzer NA to the conductor pins 122, 122, with a test piece TP of the noise suppression film attached to the microstripline MSL by an adhesive, the power of reflected waves $S_{11}$ and the power of transmitted waves $S_{12}$ are measured with incident waves of 0.1-6 GHz, to determine the transmission attenuation ratio Rtp by the following formula (1):

$$Rtp = -10 \times \log [10^{S21/10}/(1 - 10^{S11/10})] \ldots (1).$$

(b) Noise absorption ratio

In the system shown in Figs. 10(a) and 10(b), incident power $P_{in}$ = reflected wave power $S_{11}$ + transmitted wave power $S_{12}$ + absorbed power (power loss) $P_{loss}$. Accordingly, the power loss $P_{loss}$ is determined by subtracting the reflected wave power $S_{11}$ and the transmitted wave power $S_{21}$ from the incident power $P_{in}$, and the noise absorption ratio $P_{loss}/P_{in}$ is obtained by dividing $P_{loss}$ by the incident power $P_{in}$.

(2) Evaluation of thermal dissipation

The thermal dissipation of the electromagnetic-wave-absorbing film 1 is evaluated by the speed of heat given to a part of the film 1 diffusing to an entire region of the film. Specifically, a rectangular sample 200 (100 mm x 50 mm) of the electromagnetic-wave-absorbing film 1 and an acrylic support plate 201 (200 mm x 100 mm x 2 mm) having a rectangular opening 202 of the same size as the sample 200 of the electromagnetic-wave-absorbing film 1 are prepared as shown in Fig. 11(a), and the sample 200 is fixed into the opening 202 of the acrylic support plate 201 with an adhesive tape (cellophane tape) 203 of 10 mm in width as shown in Fig. 11(b) and Fig. 11(c). As shown in Fig. 11 (d), the sample 200 comprises a PET film 205 of 100 μm in thickness laminated on the side of the thin carbon nanotube layer 14 of the electromagnetic-wave-absorbing film 1.

As shown in Fig. 12, the acrylic support plate 201, to which the sample 200 is fixed, is placed on a plate 210 having an opening 211, such that the sample 200 is exposed in the opening 211, a Nichrome wire heater 220 as a heat source is placed 50 mm below the sample 200, and an infrared thermograph 230 (Thermo GEAR G100 available from NEC Avio Infrared Technologies Co., Ltd.) is fixed at a position 350 mm above the sample 200. A hot spot 251 of by the heat source 230. As shown in Fig. 13, a temperature (the highest temperature) Tmax at a center of the heated region 251, and temperatures t1, t2, t3, t4 at points 252, 253, 254, 255 20 mm from each corner on diagonal lines are automatically measured by the infrared thermograph 230. The average of the temperatures t1, t2, t3, t4 is regarded as the lowest temperature Tmin, and the average of the highest temperature and the lowest temperature is regarded as an average temperature Tav. The changes of the highest temperature Tmax, the lowest temperature Tmin and the average temperature are compared to evaluate thermal diffusion (thermal dissipation).

The present invention will be explained in more detail referring to Examples below without intention of restricting the present invention thereto.

Example 1

Using an apparatus having the structure shown in Fig. 9 comprising pattern rolls 32a, 32b having electroplated fine diamond particles having a particle size distribution of 50-80 μm, linear scratches were formed in two perpendicular directions as shown in Fig. 2(c), on a thin aluminum film 11 of 0.05 μm in thickness vacuum-vapor-deposited on one surface of a 16-μm-thick, biaxially oriented polyethylene terephthalate (PET) film. An optical photomicrograph of the linearly scratched, thin aluminum film 11 shows that the linear scratches had the following properties.

| | |
|---|---|
| Range of widths W | 0.5-5 μm, |
| Average width Wav | 2 μm, |
| Range of intervals I | 2-30 μm, |
| Average interval Iav | 20 μm, |
| Average length Lav | 5 mm, and |
| Acute crossing angle θs | 90°. |

A carbon nanotube dispersion comprising 1% by mass of multi-layer carbon nanotube (catalyst removed) having diameters of 10-15 nm and an average length of 3 μm and 1% by mass of a dispersant in methyl ethyl ketone was coated on the linearly scratched, thin aluminum film 11 by an air brush, and spontaneously dried. The resultant thin carbon nanotube layer 14 was as thick as 0.064 g/m$^2$ (coated amount). Thereafter, a 16-μm-thick PET film was heat-laminated to the thin aluminum film 11 at 120°C to obtain a sample of an electromagnetic-wave-absorbing film 1.

Each test piece TP (55.2 mm x 4.7 mm) cut out of the above electromagnetic-wave-absorbing film sample was adhered to the microstripline MSL in the system shown in Figs. 10(a) and 10(b), to measure the reflected wave power $S_{11}$ and the transmitted wave power $S_{12}$ to the incident power $P_{in}$ in a frequency range of 0.1-6 GHz. The transmission attenuation power ratio Rtp and the noise absorption ratio $P_{loss}/P_{in}$ in a frequency range of 0.1-6 GHz were determined by the methods described in [3], (1) and (2) above. The results are shown in Figs. 14 and 15.

Comparative Example 1

An electromagnetic-wave-absorbing film 1 having a linearly scratched, thin aluminum film 11 was produced in the same manner as in Example 1, without coating the thin aluminum film 11 with a carbon nanotube dispersion, and a transmission attenuation power ratio Rtp and a noise absorption ratio $P_{loss}/P_{in}$ were determined by the same methods as in Example 1 on a test piece TP cut out of the electromagnetic-wave-absorbing film 1. The results are shown in Figs. 14 and 15.

As is clear from Figs. 14 and 15, Example 1 exhibited higher transmission attenuation power ratio Rtp and noise absorption ratio $P_{loss}/P_{in}$ than those of Comparative Example 1. This indicates that the formation of the thin carbon nanotube layer 14 improves the transmission attenuation power ratio Rtp and the noise absorption ratio $P_{loss}/P_{in}$.

The thermal diffusion (thermal dissipation) of the electromagnetic-wave-absorbing films 1 of Example 1 and Comparative Example 1 was evaluated at 22°C and at humidity of 34% by the method described in [3] (2) referring to Figs. 11-13. The results are shown in Figs. 16 and 17. As is clear from Figs. 16 and 17, the electromagnetic-wave-absorbing film of Example 1 with a thin carbon nanotube layer 14 formed exhibited higher thermal diffusion than that of the electromagnetic-wave-absorbing film of Comparative Example 1 without the thin carbon nanotube layer 14.

Example 2, Comparative Example 2

Electromagnetic-wave-absorbing films 1 were produced in the same manner as in Example 1 and Comparative Example 1 except for forming a thin nickel film 11, and a test piece TP was cut out of each electromagnetic-wave-absorbing film 1 to determine a transmission attenuation power ratio Rtp and a noise absorption ratio $P_{loss}/P_{in}$ by the same methods as in Example 1. The results are shown in Figs. 18 and 19. As is clear from Figs. 18 and 19, Example 2 exhibited higher transmission attenuation power ratio Rtp and noise absorption ratio $P_{loss}/P_{in}$ than those of Comparative Example 2. This indicates that even with the thin metal film 11 of nickel, the formation of a thin carbon nanotube layer 14 improves the transmission attenuation power ratio Rtp and the noise absorption ratio $P_{loss}/P_{in}$.

Example 3

An electromagnetic-wave-absorbing film 1 was produced in the same manner as in Example 1 except for changing the crossing angle θs of linear scratches to 30°, 60° and 90°, respectively, and the transmission attenuation power ratio Rtp and the noise absorption ratio $P_{loss}/P_{in}$ were determined by the same methods as in Example 1 on a test piece TP cut out of each electromagnetic-wave-absorbing film 1. The transmission attenuation power ratios Rtp and the noise absorption ratios $P_{loss}/P_{in}$ to the incident wave having a frequency of 6 GHz are shown in Table 1. As is clear from Table 1, high transmission attenuation power ratio Rtp and noise absorption ratio $P_{loss}/P_{in}$ were obtained at any crossing angle θs of 30°-90°.

Table 1

| Crossing Angle θs (°) | Rtp at 6 GHz | $P_{loss}/P_{in}$ at 6 GHz |
|---|---|---|
| 30 | 31.0 | 0.93 |
| 60 | 32.4 | 0.95 |
| 90 | 32.6 | 0.96 |

Example 4

With respect to a test piece TP cut out of each electromagnetic-wave-absorbing film 1 produced in the same manner as in Example 1 except for changing the amount of the carbon nanotube dispersion coated as shown in Table 2 below, the transmission attenuation power ratio Rtp and the noise absorption ratio $P_{loss}/P_{in}$ were determined by the same methods as in Example 1. The transmission attenuation power ratios Rtp and the noise absorption ratios $P_{loss}/P_{in}$ to the incident wave having a frequency of 6 GHz are shown in Table 2. As is clear from Table 2, when the thin carbon nanotube layer 14 had thickness in a range of 0.01-0.1 g/m$^2$, high transmission attenuation power ratio Rtp and noise absorption ratio $P_{loss}/P_{in}$ were obtained, but outside the above thickness range, there were insufficient effects of improving the transmission attenuation power ratio Rtp and the noise absorption ratio $P_{loss}/P_{in}$.

Table 2

| Thickness of Thin Layer of CNT(1) ($g/m^2$) | Rtp at 6 GHz | $P_{loss}/P_{in}$ at 6 GHz |
|---|---|---|
| - | 19.9 | 0.94 |
| 0.01 | 21.3 | 0.94 |
| 0.05 | 32.6 | 0.96 |
| 0.1 | 32.9 | 0.95 |
| Note: (1) Multi-layer carbon nanotube. | | |

Example 5

With respect to a test piece TP cut out of an electromagnetic-wave-absorbing film 1 produced in the same manner as in Example 1 except for changing the thickness of the thin aluminum film 11 to 0.08 μm, the transmission attenuation power ratio Rtp and the noise absorption ratio $P_{loss}/P_{in}$ were measured. The results are shown in Figs. 20 and 21. As is clear from Figs. 20 and 21, the transmission attenuation power ratio Rtp and noise absorption ratio $P_{loss}/P_{in}$ in Example 5 were substantially on the same levels as in Example 1. This indicates that the electromagnetic-wave-absorbing film 1 of the present invention comprising a linearly scratched, thin metal film and a thin carbon nanotube layer 14 has excellent electromagnetic wave absorbability regardless of the thickness of the thin metal film.

Example 6

With respect to a test piece TP cut out of an electromagnetic-wave-absorbing film 1 produced in the same manner as in Example 1, except for using a two-layer, thin metal film comprising a 50-nm-thick Ni layer and a 100-nm-thick Cu layer in this order from below, the transmission attenuation power ratio Rtp and the noise absorption ratio $P_{loss}/P_{in}$ were measured. The results are shown in Figs. 22 and 23. As is clear from Figs. 22 and 23, even the two-layer, thin metal film exhibited high transmission attenuation power ratio Rtp and noise absorption ratio $P_{loss}/P_{in}$.

Comparative Example 3

A 0.05-μm-thick, thin nickel film 11 vacuum-vapor-deposited on a 16-μm-thick, biaxially stretched PET film was coated with a thin carbon nanotube layer 14 as thick as 0.060 $g/m^2$ by the same method as in Example 1, without forming linear scratches. A test piece TP cut out of the resultant sample was measured with respect to a transmission attenuation power ratio Rtp and a noise absorption ratio $P_{loss}/P_{in}$. The results are shown in Figs. 24 and 25. Figs. 24 and 25 revealed that the formation of a thin carbon nanotube layer 14 on the thin nickel film 11 free of linear scratches did not provide sufficient electromagnetic wave absorbability.

Comparative Example 4

A thin carbon nanotube layer 14 as thick as 0.061 $g/m^2$ was formed in the same manner as in Example 1 on a 16-μm-thick, biaxially stretched PET film free of a thin metal film. A test piece TP cut out of the resultant sample was measured with respect to a transmission attenuation power ratio Rtp and a noise absorption ratio $P_{loss}/P_{in}$. The results are shown in Figs. 26 and 27. Figs. 26 and 27 revealed that the formation of a thin carbon nanotube layer 14 on a thin metal film free of linear scratches did not provide sufficient electromagnetic wave absorbability.

Example 7

A sample of a 16-μm-thick, biaxially stretched PET film provided with a linearly scratched thin aluminum film 11 and a thin carbon nanotube layer 14 in the same manner as in Example 1 was divided to 10 pieces having the size shown in Table 3 below, and each piece was measured with respect to a transmission attenuation power ratio Rtp and a noise absorption ratio $P_{loss}/P_{in}$ at 6 GHz. The results are shown in Table 3. Small values of Rtp and $P_{loss}/P_{in}$ were obtained because each piece had a smaller area than that of the test piece TP (55.2 mm x 4.7 mm). As is clear from Table 3, the electromagnetic-wave-absorbing film 1 of the present invention had small unevenness in a transmission attenuation power ratio Rtp and a noise absorption ratio $P_{loss}/P_{in}$ even when divided to small pieces. This appears to be due to the fact that the unevenness of randomly formed linear scratches was averaged by the thin carbon nanotube layer 14.

Table 3

| Size of Piece (cm x cm) | Rtp (dB) at 6 GHz | | $P_{loss}/P_{in}$ at 6 GHz | |
|---|---|---|---|---|
| | Range | Average | Range | Average |
| 5 x 1 | 13.9-15.5 | 14.6 | 0.91-0.96 | 0.95 |
| 4 x 1 | 10.1-11.2 | 10.5 | 0.87-0.94 | 0.91 |
| 3 x 1 | 7.0-8.1 | 7.6 | 0.77-0.85 | 0.82 |
| 2 x 1 | 5.3-6.3 | 5.8 | 0.68-0.76 | 0.73 |
| 1 x 1 | 1.8-2.6 | 2.3 | 0.39-0.48 | 0.44 |

Comparative Example 5

A sample of a 16-μm-thick, biaxially stretched PET film provided with a linearly scratched, thin aluminum film 11 in the same manner as in Example 1 (free of a thin carbon nanotube layer 14) was divided to 10 pieces having the size shown in Table 4 below, and each piece was measured with respect to a transmission attenuation power ratio Rtp and a noise absorption ratio $P_{loss}/P_{in}$ were measured. The results are shown in Table 4. As is clear from Table 4, when the electromagnetic-wave-absorbing film free of a thin carbon nanotube layer 14 was divided to small pieces, the unevenness of the transmission attenuation power ratio Rtp and the noise absorption ratio $P_{loss}/P_{in}$ became larger than that of Example 7 having the thin carbon nanotube layer 14.

Table 4

| Size of Small Piece (cm x cm) | Rtp (dB) at 6 GHz | | $P_{loss}/P_{in}$ at 6 GHz | |
|---|---|---|---|---|
| | Range | Average | Range | Average |
| 5 x 1 | 11.3-13.2 | 12.6 | 0.89-0.94 | 0.93 |
| 4 x 1 | 6.1-7.5 | 6.9 | 0.75-0.83 | 0.80 |
| 3 x 1 | 5.5-7.0 | 6.3 | 0.72-0.80 | 0.76 |
| 2 x 1 | 3.8-5.5 | 4.6 | 0.58-0.71 | 0.65 |
| 1 x 1 | 0.8-2.1 | 1.6 | 0.25-0.40 | 0.31 |

Example 8 and Comparative Example 6

The electromagnetic-wave-absorbing film 1 of Example 8 was produced in the same manner as in Example 1, except for using a carbon nanotube dispersion comprising 0.5% by mass of multi-layer carbon nanotube having diameters of 10-15 nm and an average length of 3 μm (a catalyst removed), which was uniformly dispersed in 98% by mass of a mixed solvent (xylene/isopropyl alcohol (IPA) = 6/4), and further 1.5% by mass of polymethylmethacrylate (PMMA) dissolved in the mixed solvent. A test piece TP cut out of this electromagnetic-wave-absorbing film 1 was measured with respect to a noise absorption ratio $P_{loss}/P_{in}$ by the same method as in Example 1, and a sample cut out of this electromagnetic-wave-absorbing film 1 was evaluated with respect to thermal diffusion (thermal dissipation) by the same method as in Example 1. The noise absorption ratio $P_{loss}/P_{in}$ measured is shown in Fig. 28, and the thermal diffusion (thermal dissipation) evaluated is shown in Fig. 29. Also, the same test piece TP as in Example 8 was measured after six months with respect to a noise absorption ratio $P_{loss}/P_{in}$. The results are shown in Fig. 30. As is clear from Fig. 29, the electromagnetic-wave-absorbing film 1 of Example 8 having a thin carbon nanotube layer 14 containing a binder resin had good thermal diffusion.

The electromagnetic-wave-absorbing film sample of Comparative Example 6 was produced in the same manner as in Example 8 except that a catalyst was not removed from the carbon nanotube dispersion of Example 8, and measured with respect to a noise absorption ratio $P_{loss}/P_{in}$. The results are shown in Fig. 31. Also, the same sample was measured after six months with respect to a noise absorption ratio $P_{loss}/P_{in}$ by the same method. The results are shown in Fig. 32.

As is clear from Figs. 28 and 30, the electromagnetic-wave-absorbing film 1 of Example 8 using the catalyst-free carbon nanotube suffered substantially no deterioration with time of electromagnetic wave absorbability. On the other hand, as is clear from Figs. 31 and 32, the electromagnetic-wave-absorbing film 1 of Comparative Example 6 using catalyst-remaining carbon nanotube suffered large deterioration with time of electromagnetic wave absorbability.

Comparative Example 7

An electromagnetic-wave-absorbing film was produced in the same manner as in Example 1, except for using a carbon nanotube dispersion comprising 1.0% by mass of multi-layer carbon nanotube having an average length of 1 μm and 1.0% by mass of PMMA, and a test piece TP cut out thereof was measured with respect to a transmission attenuation power ratio Rtp and a noise absorption ratio $P_{loss}/P_{in}$ by the same methods as in Example 1. The results are shown in Figs. 33 and 34. As is clear from Figs. 33 and 34, Comparative Example 7 exhibited both transmission attenuation power ratio Rtp and noise absorption ratio $P_{loss}/P_{in}$ substantially on the same levels as those of Comparative Example 1. This indicates that when the carbon nanotube has an average length of less than 2 μm, the thin carbon nanotube layer 14 provides substantially no effect.

Example 9

An electromagnetic-wave-absorbing film 1 was produced in the same manner as in Example 8 except for changing the concentration of carbon nanotube to 1.3% by mass, and measured with respect to a noise absorption ratio $P_{loss}/P_{in}$ and thermal diffusion (thermal dissipation) by the same methods as in Example 1. The results are shown in Figs. 35 and 36. As is clear from Figs. 35 and 36, even with the concentration of carbon nanotube changed, there was substantially no change in the electromagnetic wave absorbability and thermal diffusion of the resultant electromagnetic-wave-absorbing film.

Comparative Example 8

A sample obtained by coating a 16-μm-thick PET film free of a thin aluminum film 11 with the same carbon nanotube dispersion as in Example 8 was measured with respect to a noise absorption ratio $P_{loss}/P_{in}$ and thermal diffusion (thermal dissipation) by the same methods as in Example 1. The results are shown in Figs. 37 and 38.

Comparative Example 9

A sample of a 16-μm-thick PET film having a 0.05-μm-thick, thin aluminum film 11 free of linear scratches was coated with the same carbon nanotube dispersion as in Example 8, and measured with respect to a noise absorption ratio $P_{loss}/P_{in}$ and thermal diffusion (thermal dissipation) by the same methods as in Example 1. The results are shown in Figs. 39 and 40.

Comparative Example 10

A sample having only a 0.05-μm-thick thin aluminum film 11 formed on a surface of a 16-μm-thick PET film was evaluated with respect to thermal diffusion (thermal dissipation) by the same method as in Example 1. The results are shown in Fig. 41.

As is clear from Figs. 39-41, the electromagnetic-wave-absorbing film of Comparative Example 9, in which a thin carbon nanotube layer 14 was formed on a thin aluminum film 11 free of linear scratches, and the electromagnetic-wave-absorbing film of Comparative Example 10, in which only a thin aluminum film 11 free of linear scratches was formed, exhibited not only low noise absorption ratios $P_{loss}/P_{in}$, but also low thermal diffusion (thermal dissipation). This indicates that (a) the mere formation of the thin aluminum film cannot provide sufficient electromagnetic wave absorbability and thermal diffusion (thermal dissipation), and (b) the formation of the thin carbon nanotube layer 14 on the thin aluminum film 11 free of linear scratches fails to provide sufficient electromagnetic wave absorbability and thermal diffusion (thermal dissipation). Of course, as is clear from Figs. 37 and 38, the electromagnetic-wave-absorbing film of Comparative Example 8, in which only the thin carbon nanotube layer 14 was formed, did not exhibit sufficient electromagnetic wave absorbability and thermal diffusion (thermal dissipation).

The comparison of the electromagnetic-wave-absorbing film of Comparative Example 1, in which the linearly scratched, thin aluminum film 11 was not coated with a thin carbon nanotube layer 14, with the electromagnetic-wave-absorbing film 1 of Example 8, in which the linearly scratched, thin aluminum film 11 was coated with a thin carbon nanotube layer 14, revealed extremely improved thermal diffusion (thermal dissipation). This indicates that a combination of the linearly scratched, thin aluminum film 11 with the thin carbon nanotube layer 14 provides remarkably improved thermal diffusion (thermal dissipation) as compared with a case where they are used alone.

Comparative Example 11

A PGS graphite sheet (thickness: 17 μm) available from Panasonic Corporation was evaluated with respect to thermal diffusion by the same method as in Example 1. The results are shown in Fig. 42. As is clear from Fig. 42, the thermal diffusion of the graphite sheet was poorer than that of the electromagnetic-wave-absorbing film of the present invention.

Reference Example 1

An electromagnetic-wave-absorbing film was produced in the same manner as in Example 1, except for forming only linear scratches on a biaxially stretched PET film in one direction (longitudinal direction of the PET film), and a first test piece TP with linear scratches extending along its longitudinal direction and a second test piece TP with linear scratches extending along its transverse direction were cut out of the electromagnetic-wave-absorbing film to measure a transmission attenuation power ratio Rtp and a noise absorption ratio $P_{loss}/P_{in}$ by the same methods as in Example 1. Their transmission attenuation power ratios Rtp and noise absorption ratios $P_{loss}/P_{in}$ at 6 GHz are shown in Table 5. As is clear from Table 5, the electromagnetic-wave-absorbing film having the thin carbon nanotube layer 14 formed on the thin aluminum film 11 with mono-directional linear scratches had high electromagnetic wave absorbability, but its anisotropy was large.

Table 5

| Orientation of linear scratches | Rtp at 6 GHz | $P_{loss}/P_{in}$ at 6 GHz |
|---|---|---|
| Longitudinal direction of test piece | 34.5 | 0.88 |
| Transverse direction of test piece | 19.8 | 0.89 |

EFFECTS OF THE INVENTION

Because the electromagnetic-wave-absorbing film of the present invention have linear scratches formed in plural directions on a thin metal film, and further a thin carbon nanotube layer formed thereon, it has excellent absorbability to electromagnetic waves of various frequencies with low anisotropy, and suffers little unevenness in electromagnetic wave absorbability even when divided to small pieces. In addition, the electromagnetic-wave-absorbing film of the present invention has higher thermal diffusion (thermal dissipation) than that of an expensive graphite sheet. The electromagnetic-wave-absorbing film of the present invention having such features can be suitably used as a heat-dissipating noise suppression sheet in electronic communications apparatuses such as cell phones, smartphones, etc., electronic apparatuses such as note-type, personal computers, ultrabooks, etc..

## Claims

1. An electromagnetic-wave-absorbing film (1) comprising a plastic film (10), and a single- or multi-layer thin metal film (11) formed on at least one surface of the plastic film (10); said thin metal film (11) is provided with large numbers of substantially parallel, intermittent, linear scratches (12) with irregular widths and irregular intervals in plural directions; said linear scratches (12) having widths in a range of 0.1 - 100 μm for 90 % or more and 1 - 50 μm on average, and transverse intervals in a range of 1 - 500 μm and 1 - 200 μm on average; **characterized in that** said metal film (11) is coated with a thin carbon nanotube layer (14); and said carbon nanotube having average length of 2 μm or more.

2. The electromagnetic-wave-absorbing film (1) according to claim 1, wherein said linear scratches (12) are oriented in two directions with a crossing angle of 30 - 90°.

3. The electromagnetic-wave-absorbing film (1) according to claim 1 or 2, wherein said carbon nanotube is free of a catalyst.

4. The electromagnetic-wave-absorbing film (1) according to any one of claims 1 to 3, wherein said thin metal film (11) is made of at least one metal selected from the group consisting of aluminum, copper, silver, tin, nickel, cobalt, chromium and these alloys.

5. The electromagnetic-wave-absorbing film (1) according to any one of claims 1 to 4, wherein the thickness of said thin carbon nanotube layer (14) is 0.01 - 0.5 g/$m^2$ when expressed by the mass of carbon nanotube coated.

6. The electromagnetic-wave-absorbing film (1) according to any one of claims 1 to 5, wherein said carbon nanotube is a multi-layer carbon nanotube.

7. The electromagnetic-wave-absorbing film (1) according to any one of claims 1 to 6, wherein said thin carbon nanotube layer (14) contains a binder resin.

8. The electromagnetic-wave-absorbing film (1) according to any one of claims 1 to 7, wherein a plastic film is heat-laminated on said thin carbon nanotube layer (14).

**Patentansprüche**

1. Elektromagnetische Wellen absorbierende Folie (1), umfassend einen Kunststoff-Film (10), und einen ein- oder mehrschichtigen dünnen Metallfilm (11), der auf wenigstens einer Oberfläche des Kunststoff-Films (10) gebildet ist; worin der dünne Metallfilm (11) mit einer großen Anzahl von im Wesentlichen parallelen, unterbrochenen, linearen Kratzern (12) mit unregelmäßigen Breiten und unregelmäßigen Intervallen in mehreren Richtungen versehen ist; worin die linearen Kratzer (12) Breiten in einem Bereich von 0,1 - 100 µm für 90 % oder mehr und 1 - 50 µm im Mittel aufweisen, und querverlaufende Intervalle in einem Bereich von 1 - 500 µm und 1 - 200 µm im Mittel aufweisen; **dadurch gekennzeichnet, dass** der Metallfilm (11) mit einer dünnen Kohlenstoff-Nanoröhrchen-Schicht (14) beschichtet ist; und die Kohlenstoff-Nanoröhren eine mittlere Länge von 2 µm oder mehr aufweisen.

2. Elektromagnetische Wellen absorbierende Folie (1) nach Anspruch 1, worin die linearen Kratzer (12) in zwei Richtungen mit einem Kreuzungswinkel von 30 - 90 ° orientiert sind.

3. Elektromagnetische Wellen absorbierende Folie (1) nach Anspruch 1 oder 2, worin die Kohlenstoff-Nanoröhren frei sind von Katalysator.

4. Elektromagnetische Wellen absorbierende Folie (1) nach irgendeinem der Ansprüche 1 bis 3, worin der dünne Metallfilm (11) hergestellt ist aus wenigstens einem Metall, das ausgewählt ist aus der Gruppe, die besteht aus Aluminium, Kupfer, Silber, Zinn, Nickel, Kobalt, Chrom und deren Legierungen.

5. Elektromagnetische Wellen absorbierende Folie (1) nach irgendeinem der Ansprüche 1 bis 4, worin die Dicke der dünnen Kohlenstoff-Nanoröhrchen-Schicht (14) 0,01 - 0,5 g/$m^2$ ist, ausgedrückt durch die Masse der beschichtungsmäßig aufgetragenen Kohlenstoff-Nanoröhrchen.

6. Elektromagnetische Wellen absorbierende Folie (1) nach irgendeinem der Ansprüche 1 bis 5, worin die Kohlenstoff-Nanoröhrchen Mehrschichten-Kohlenstoff-Nanoröhrchen sind.

7. Elektromagnetische Wellen absorbierende Folie (1) nach irgendeinem der Ansprüche 1 bis 6, worin die dünne Kohlenstoff-Nanoröhrchen-Schicht (14) ein Bindemittel-Harz enthält.

8. Elektromagnetische Wellen absorbierende Folie (1) nach irgendeinem der Ansprüche 1 bis 7, worin ein Kunststoff-Film auf die dünne Kohlenstoff-Nanoröhrchen-Schicht (14) hitzelaminiert aufgetragen ist.

**Revendications**

1. Film absorbant les ondes électromagnétiques (1) comportant un film plastique (10) et un film mince métallique monocouche ou multicouche (11) formé sur au moins une surface du film plastique (10) ; ledit film mince métallique (11) étant pourvu d'un grand nombre de marques linéaires intermittentes (12) sensiblement parallèles avec des largeurs irrégulières et des intervalles irréguliers dans une pluralité de directions ; lesdites marques linéaires (12) ayant des largeurs comprises entre 0,1 et 100 µm à 90% ou plus et 1 - 50 µm en moyenne, et des intervalles transversaux compris entre 1 et 500 µm et 1 - 200 µm en moyenne ; **caractérisé en ce que** ledit film métallique (11) est revêtu d'une couche mince (14) de nanotubes de carbone ; et que lesdits nanotubes de carbone ont une longueur moyenne de 2 µm ou plus.

2. Film absorbant les ondes électromagnétiques (1) selon la revendication 1, dans lequel lesdites marques linéaires (12) sont orientées dans deux directions avec un angle d'intersection de 30 - 90°.

3. Film absorbant les ondes électromagnétiques (1) selon la revendication 1 ou 2, dans lequel ledit nanotube de carbone est dépourvu de catalyseur.

4. Film absorbant les ondes électromagnétiques (1) selon l'une quelconque des revendications 1 à 3, dans lequel ledit film mince métallique (11) est composé d'au moins un métal choisi parmi le groupe comprenant l'aluminium, le cuivre, l'argent, l'étain, le nickel, le cobalt, le chrome et leurs alliages.

5. Film absorbant les ondes électromagnétiques (1) selon l'une quelconque des revendications 1 à 4, dans lequel l'épaisseur de ladite couche mince de nanotubes de carbone (14) est de 0,01 - 0,5 $g/m^2$ lorsqu'exprimée en masse de nanotubes de carbone appliquée.

6. Film absorbant les ondes électromagnétiques (1) selon l'une quelconque des revendications 1 à 5, dans lequel ledit nanotube de carbone est un nanotube de carbone multicouche.

7. Film absorbant les ondes électromagnétiques (1) selon l'une quelconque des revendications 1 à 6, dans lequel ladite couche mince de nanotubes de carbone (14) contient une résine servant de liant.

8. Film absorbant les ondes électromagnétiques (1) selon l'une quelconque des revendications 1 à 7, dans lequel un film plastique est laminé à chaud sur ladite couche mince de nanotube de carbone (14).

Fig. 1(a)

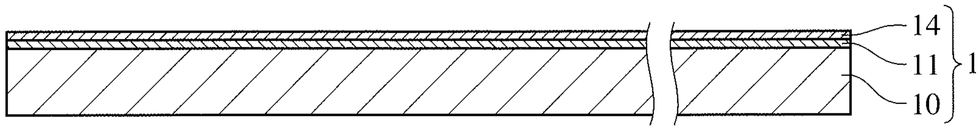


Fig. 1(b)

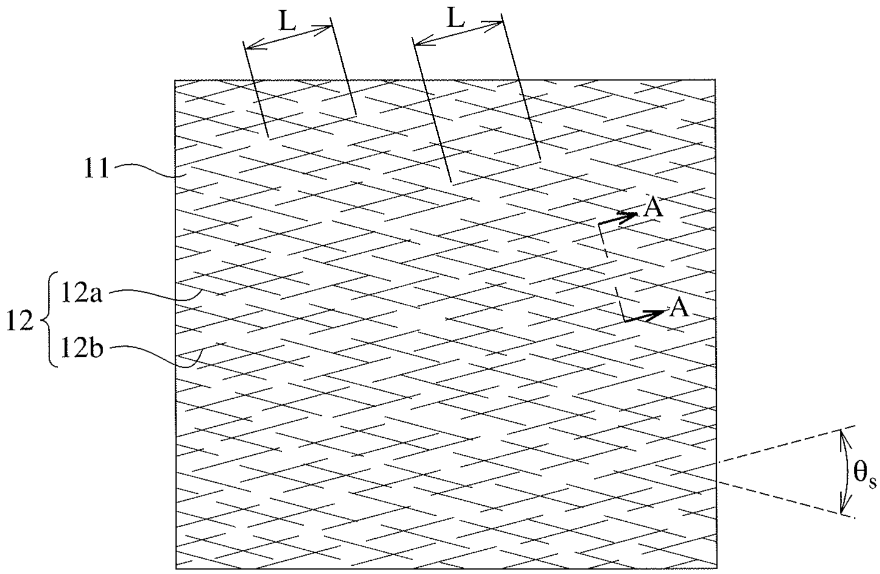


Fig. 1(c)

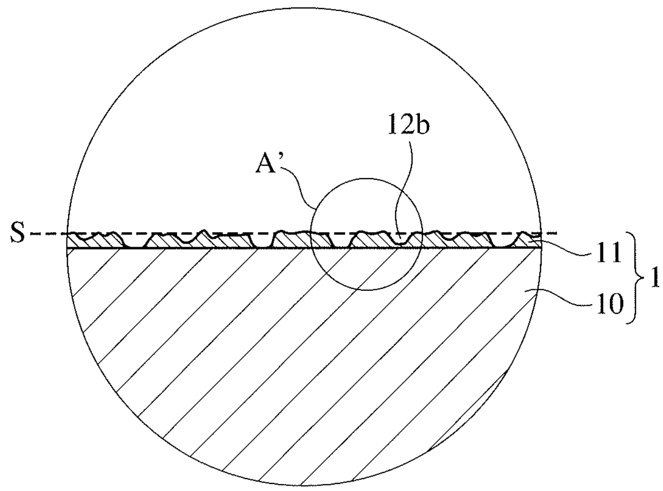

Fig. 1(d)

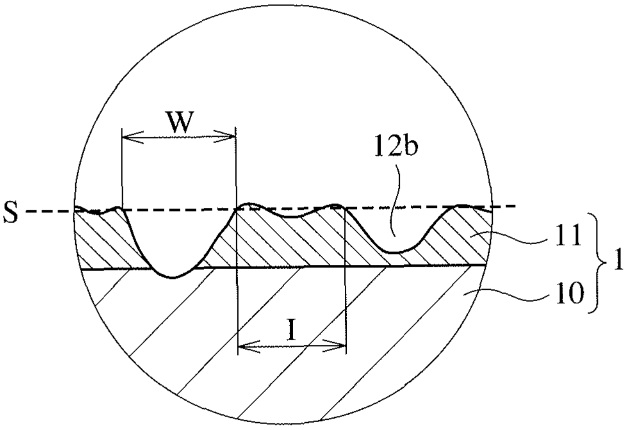


Fig. 1(e)

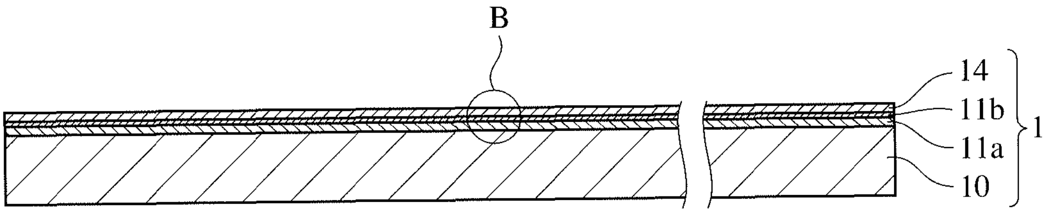


Fig. 1(f)

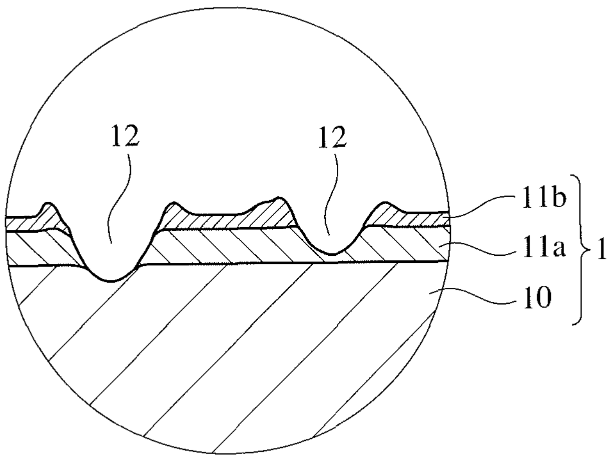

Fig. 2(a)

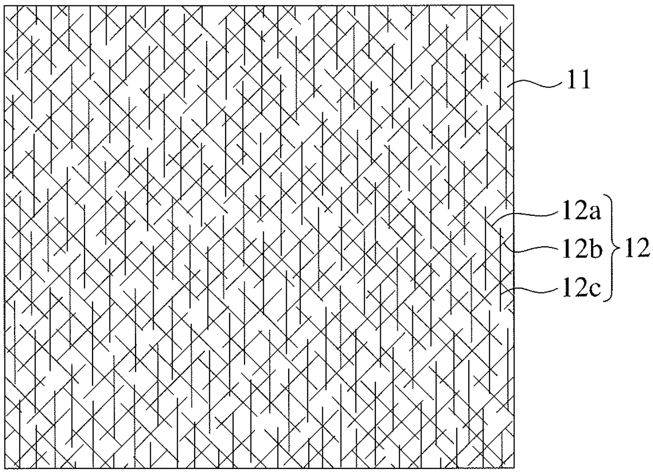


Fig. 2(b)

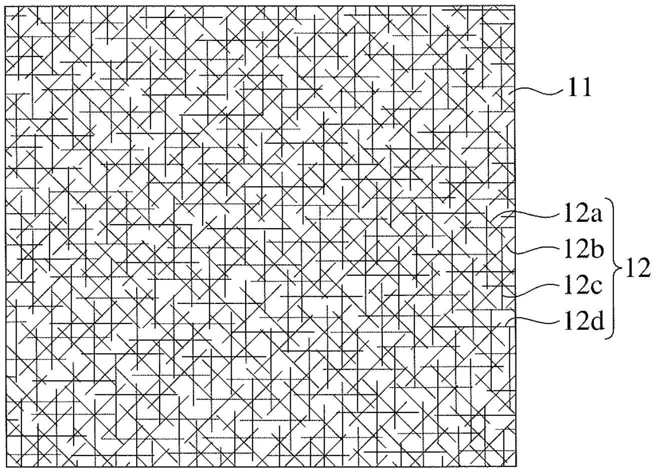


Fig. 2(c)

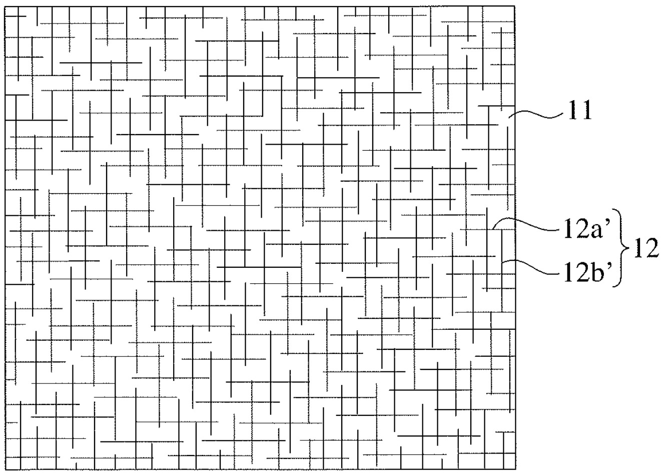

Fig. 3(a)

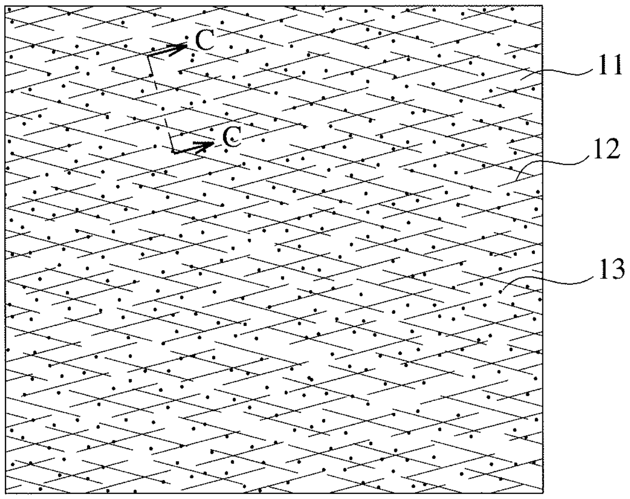


Fig. 3(b)

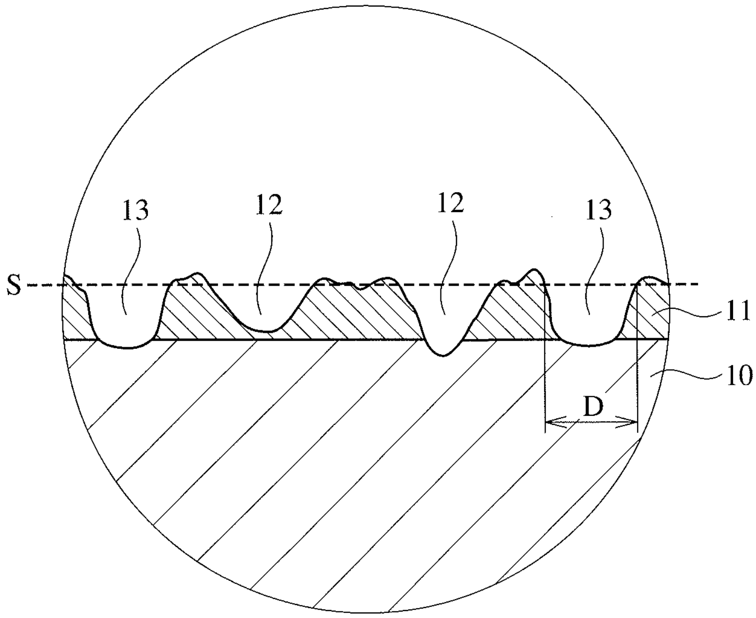


Fig. 4

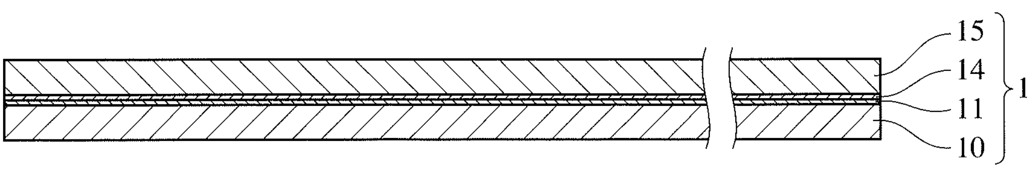

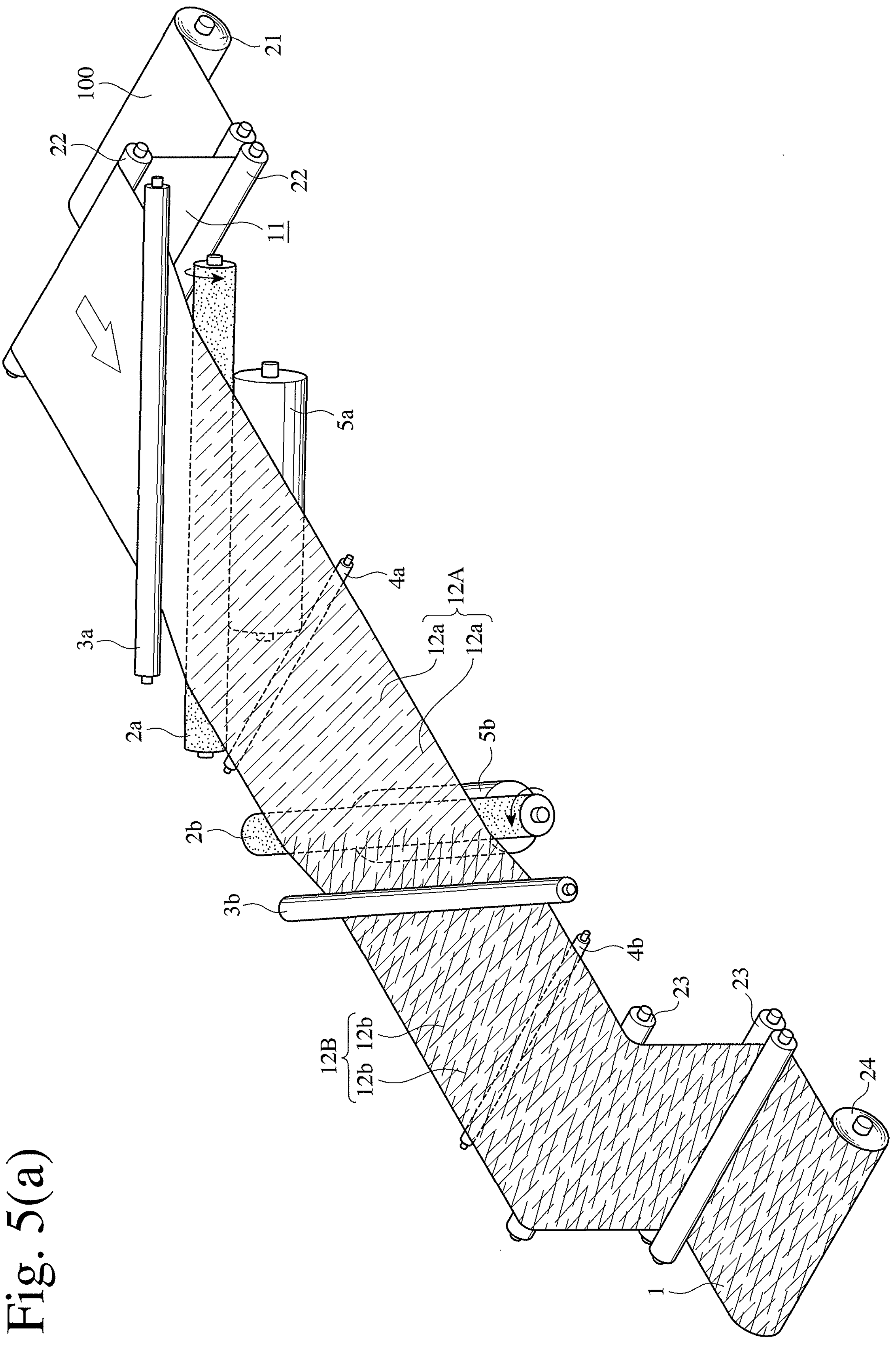
21
100
22
22
11
5a
4a
12A
12a
12a
3a
2a
5b
2b
3b
4b
23
23
12B
12b
12b
24
1

Fig. 5(a)

Fig. 5(b)

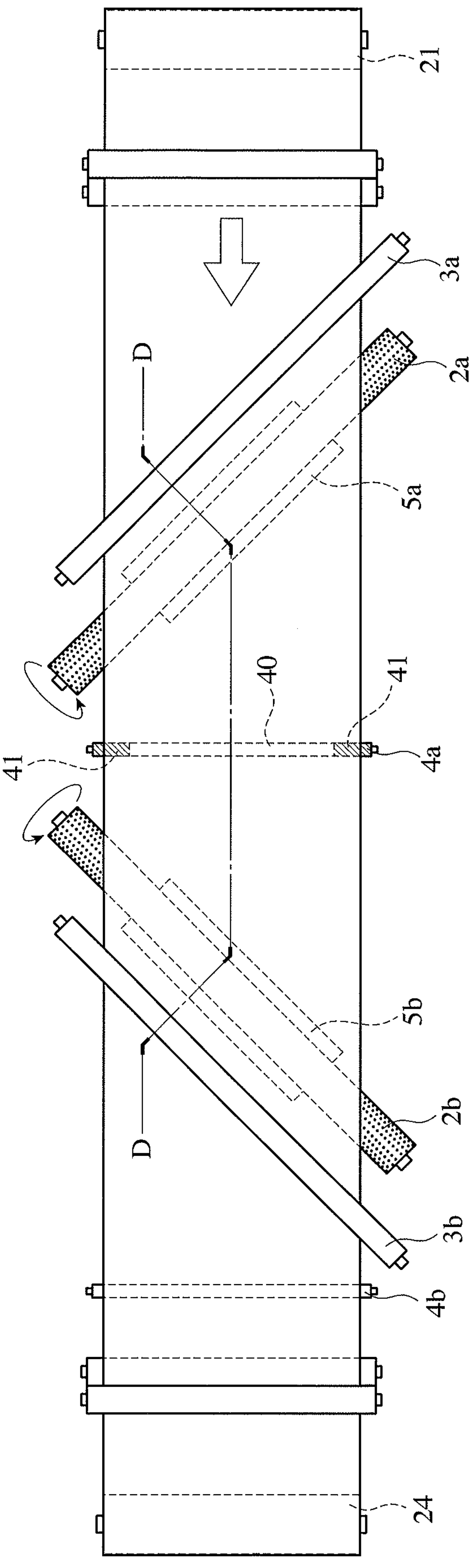

Fig. 5(c)

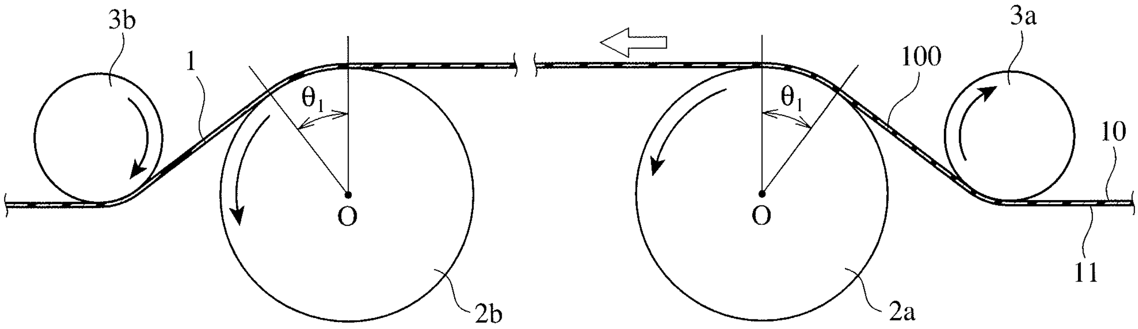
3b
1
θ1
O
2b
θ1
O
2a
100
3a
10
11

Fig. 5(d)

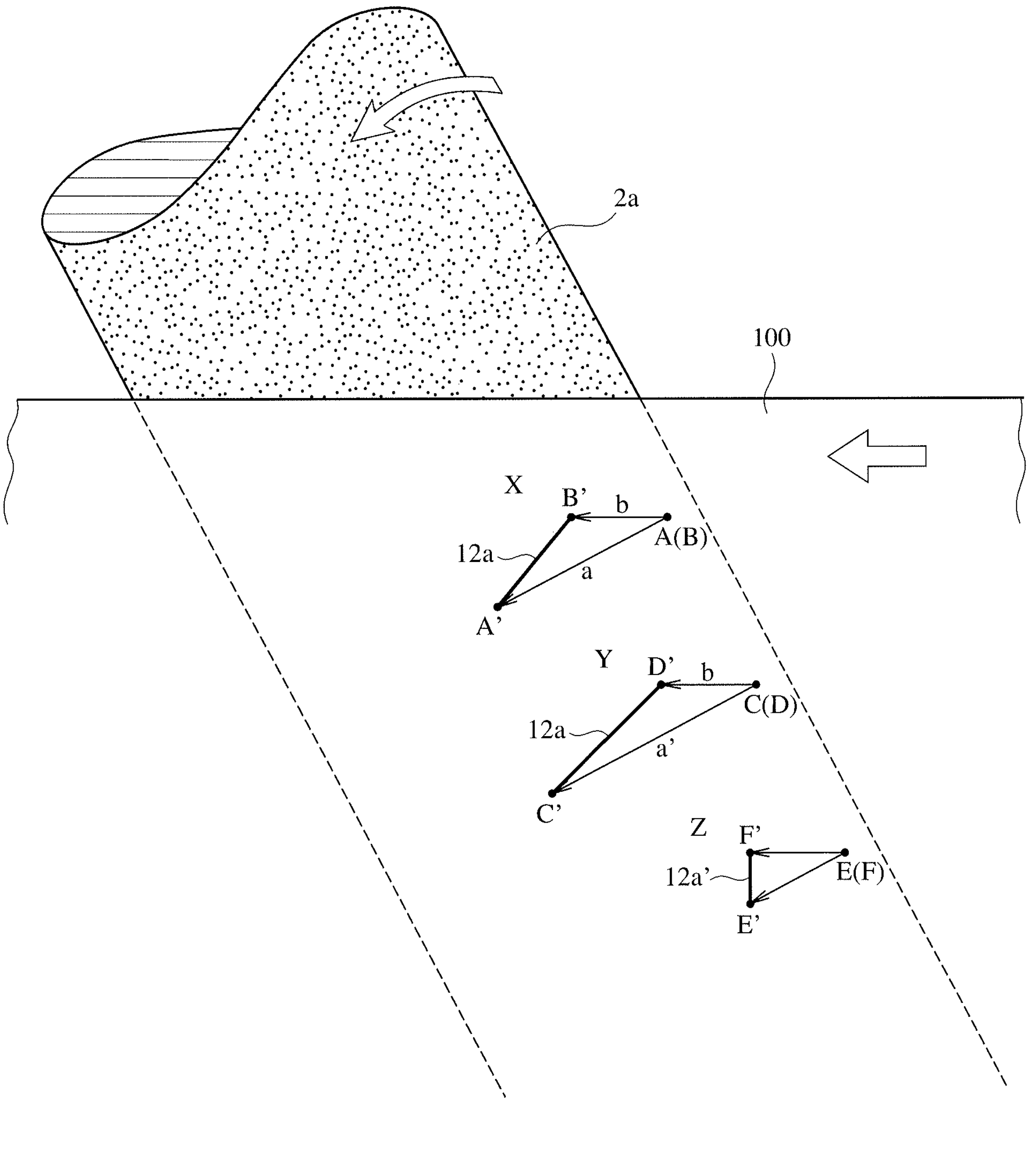
2a
100
X
B'
b
A(B)
12a
a
A'
Y
D'
b
C(D)
12a
a'
C'
Z
F'
12a'
E(F)
E'

Fig. 5(e)

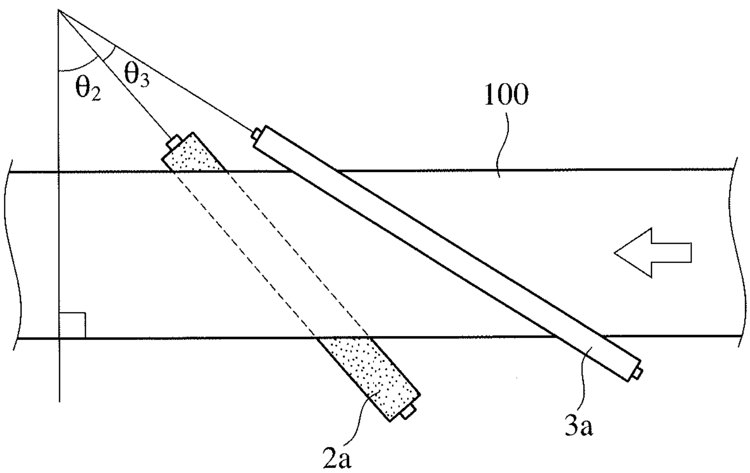


Fig. 6

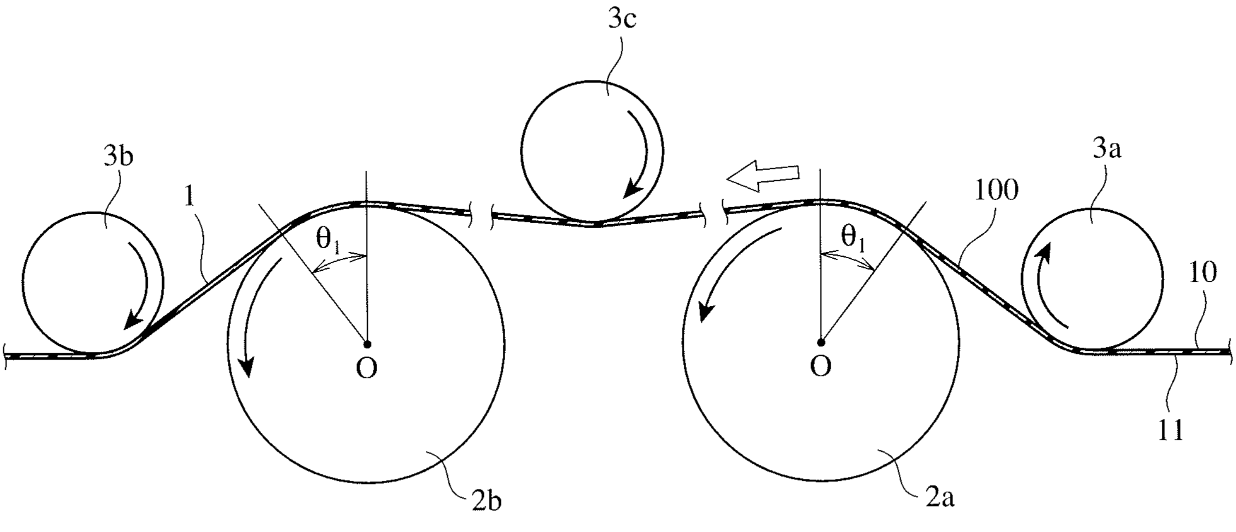

Fig. 7

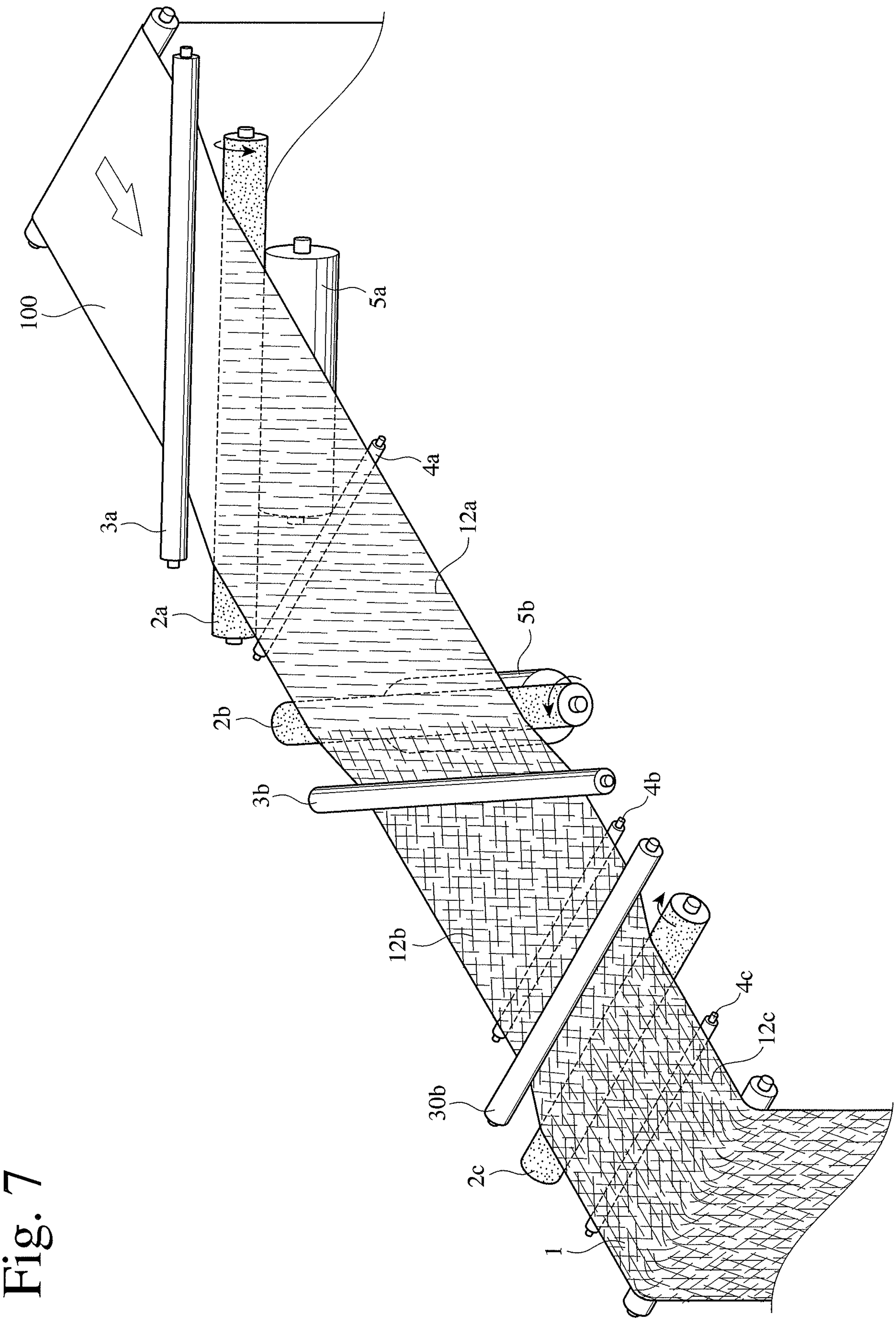

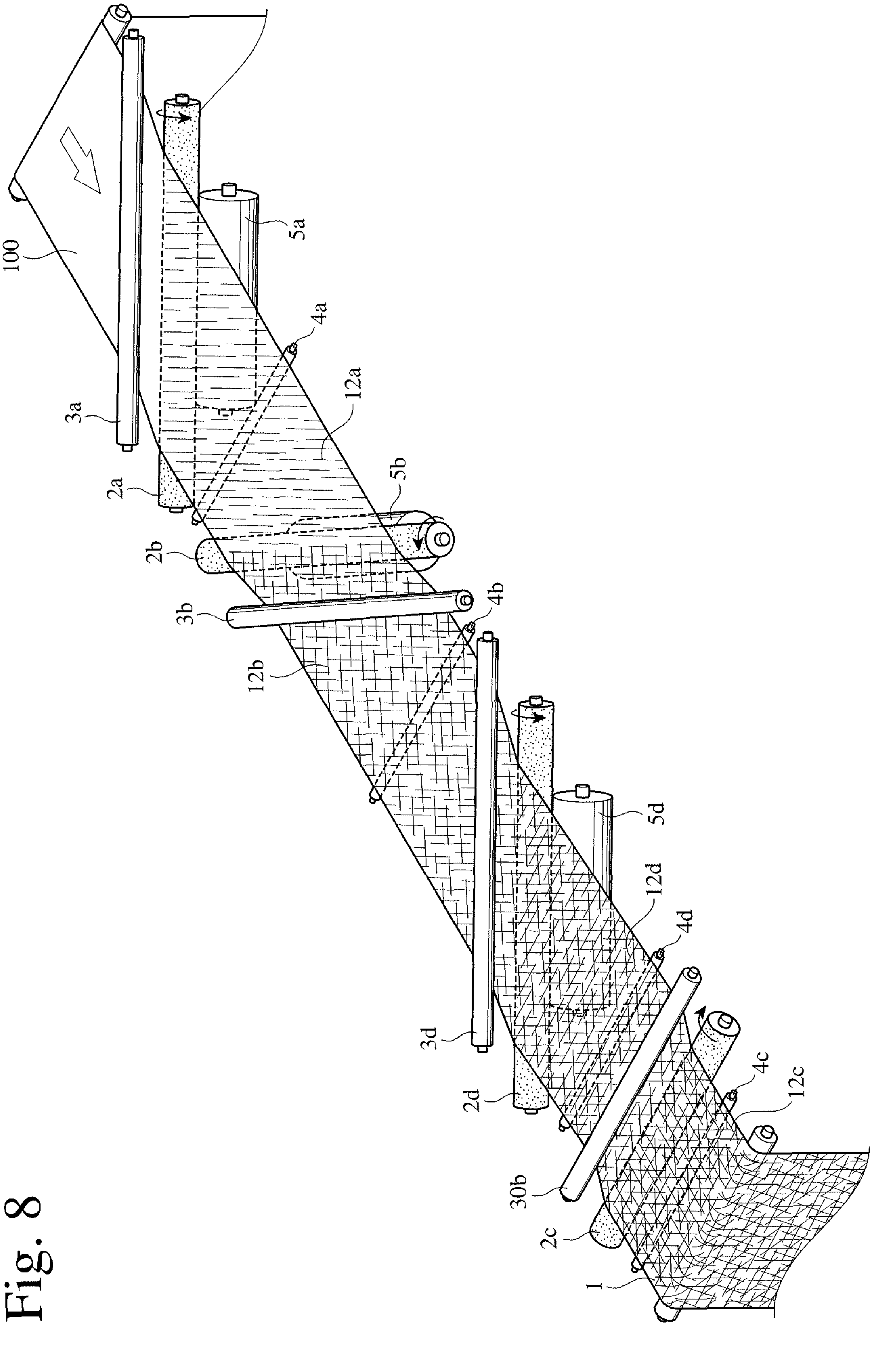


Fig. 8

Fig. 9

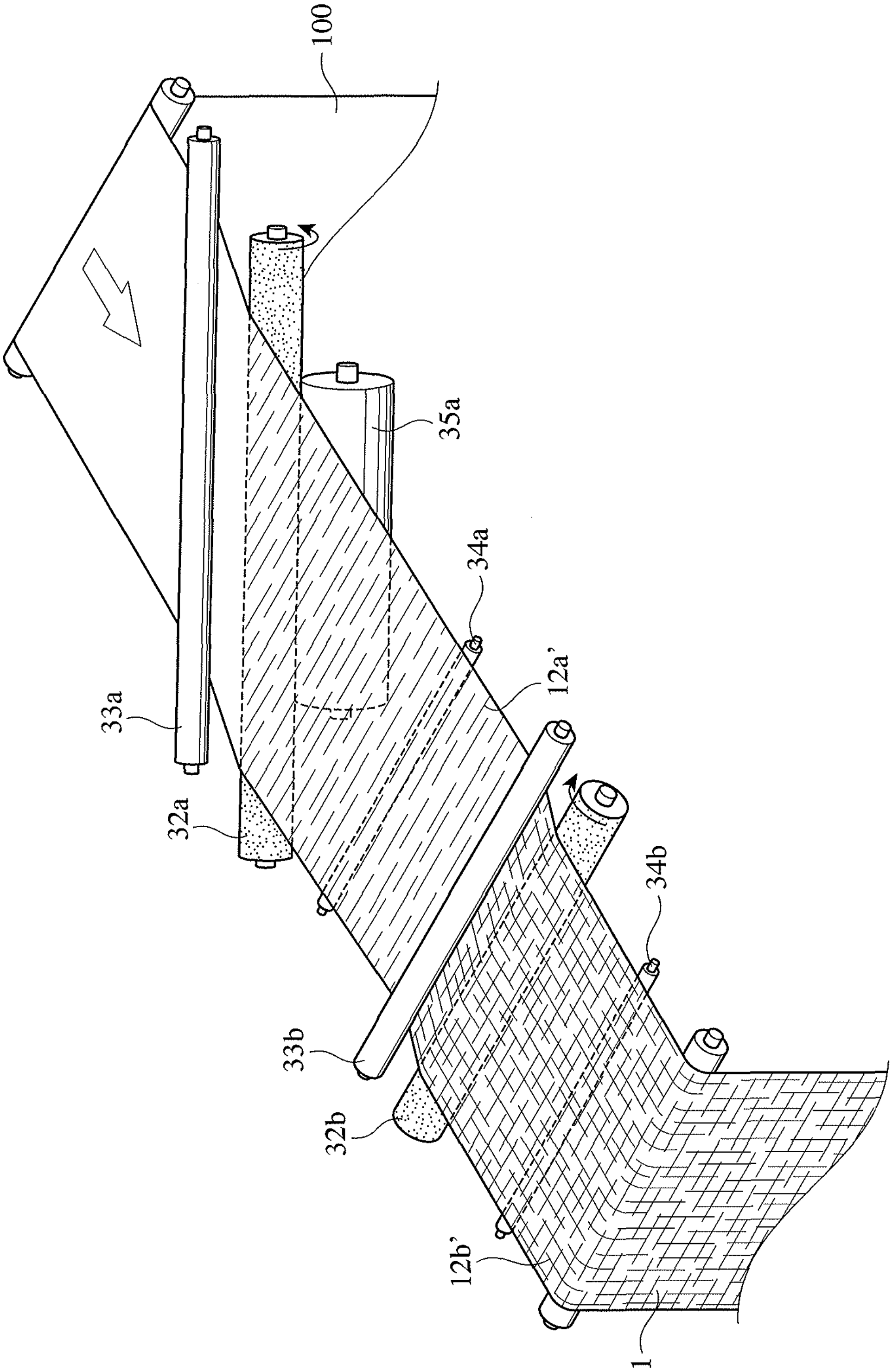

Fig. 10(a)

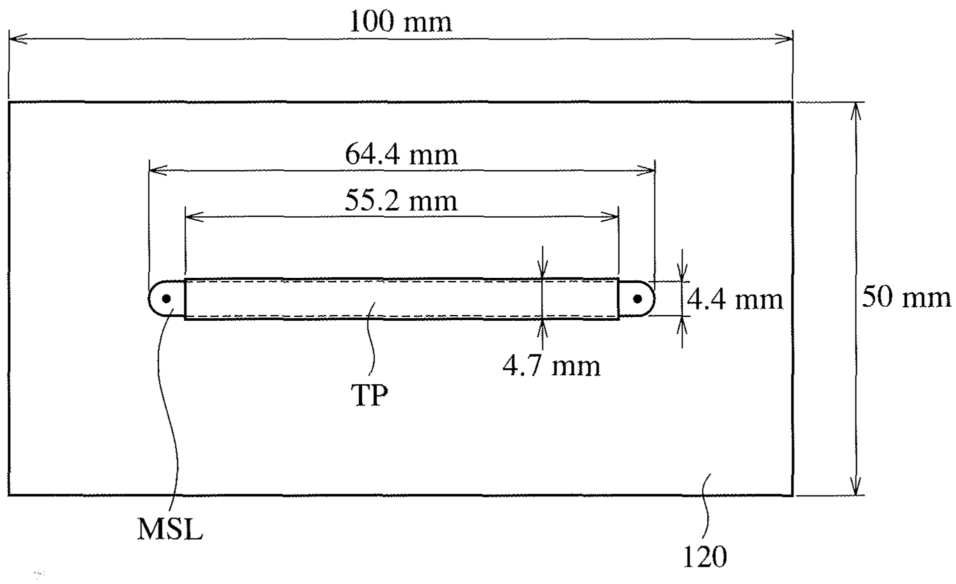


Fig. 10(b)

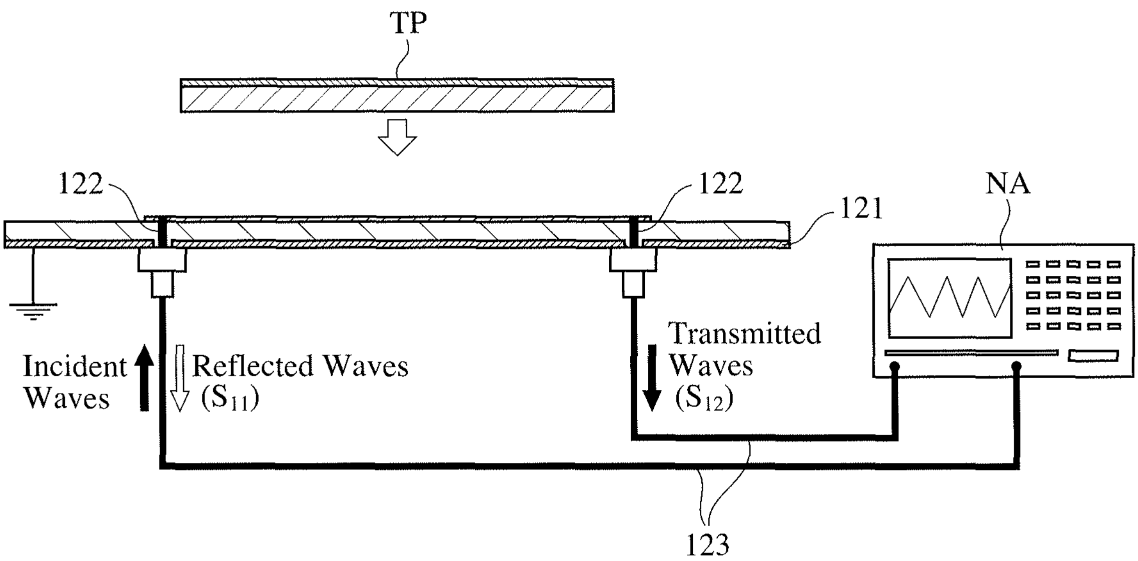

Fig. 11(a)

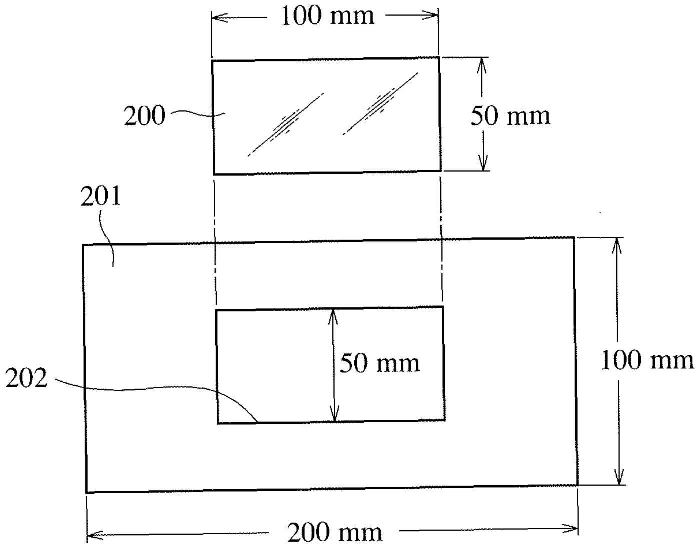


Fig. 11(b)

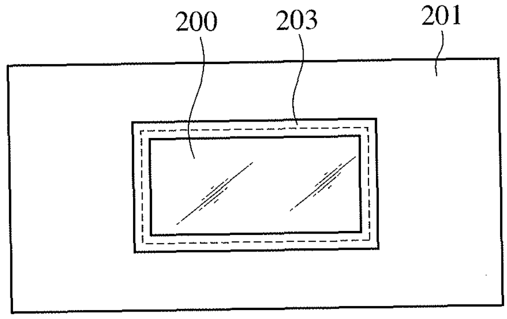


Fig. 11(c)

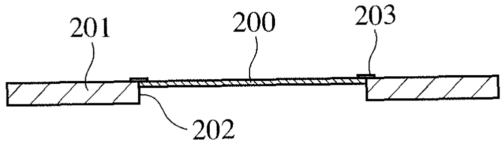


Fig. 11(d)

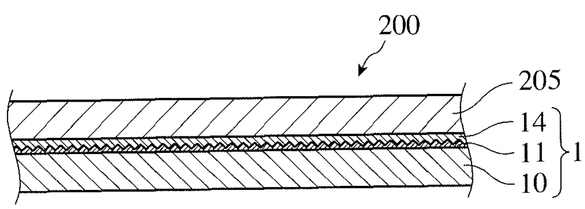

Fig. 12

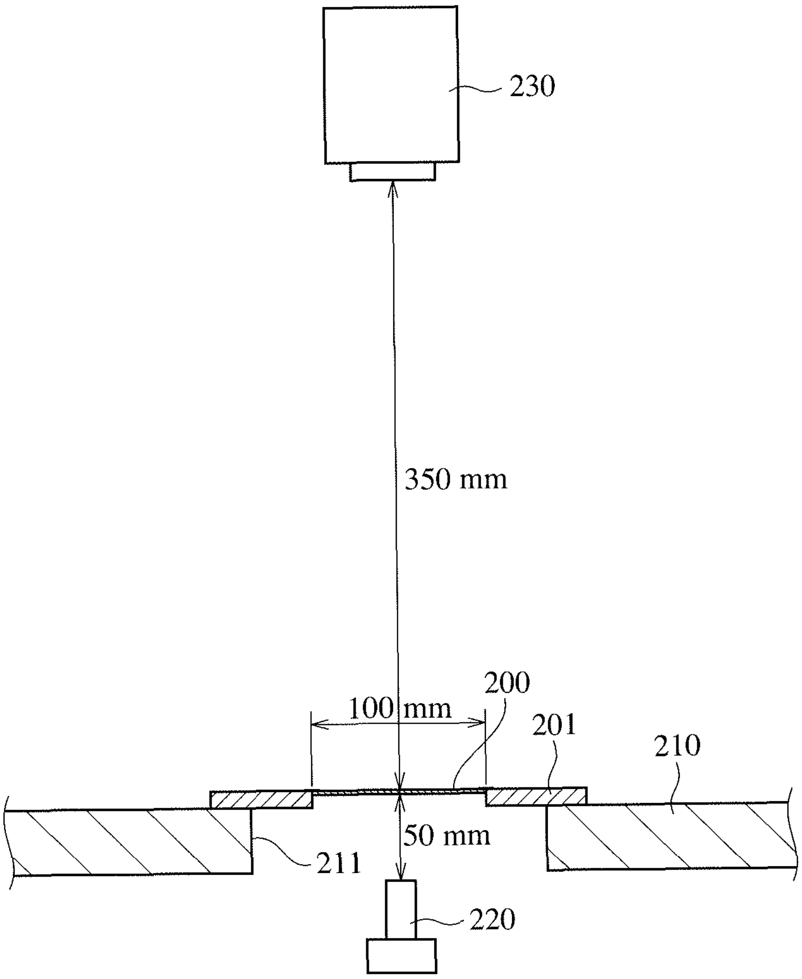
230
350 mm
100 mm
200
201
210
50 mm
211
220

Fig. 13

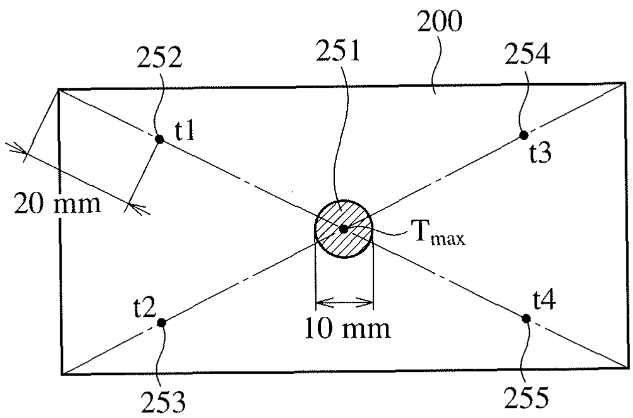
200
252
251
254
t1
t3
20 mm
$T_{max}$
t2
10 mm
t4
253
255

Fig. 14

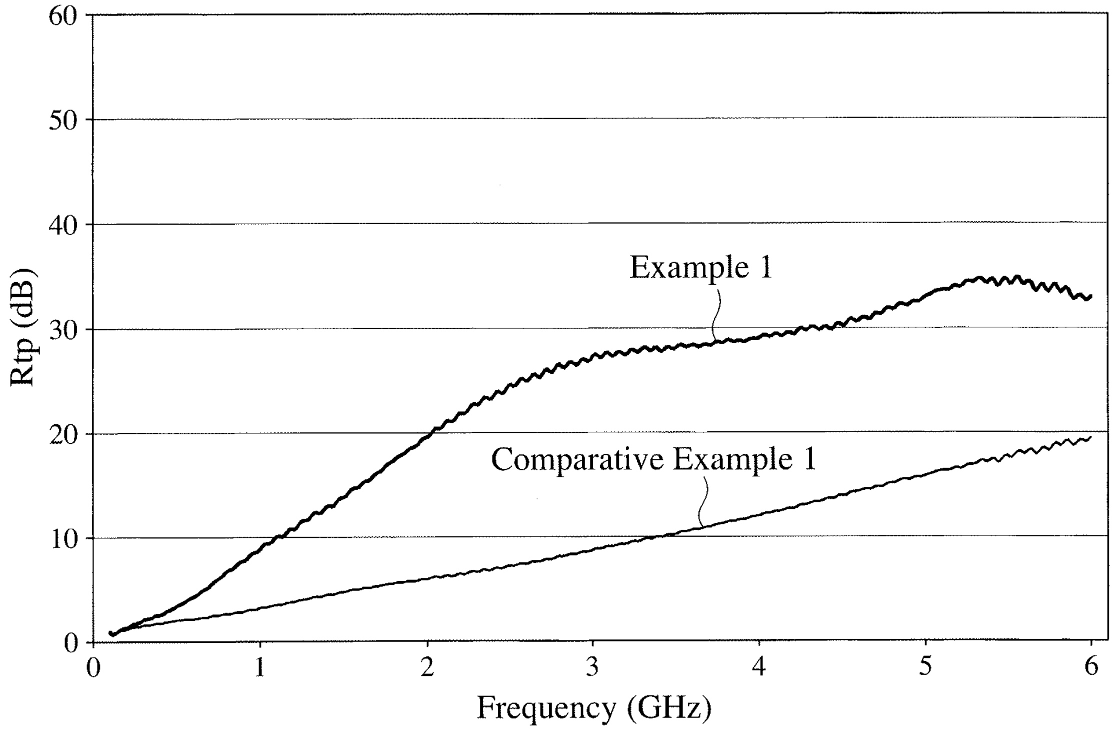

60
50
40
30
20
10
0
Rtp (dB)
Example 1
Comparative Example 1
0
1
2
3
4
5
6
Frequency (GHz)


Fig. 15

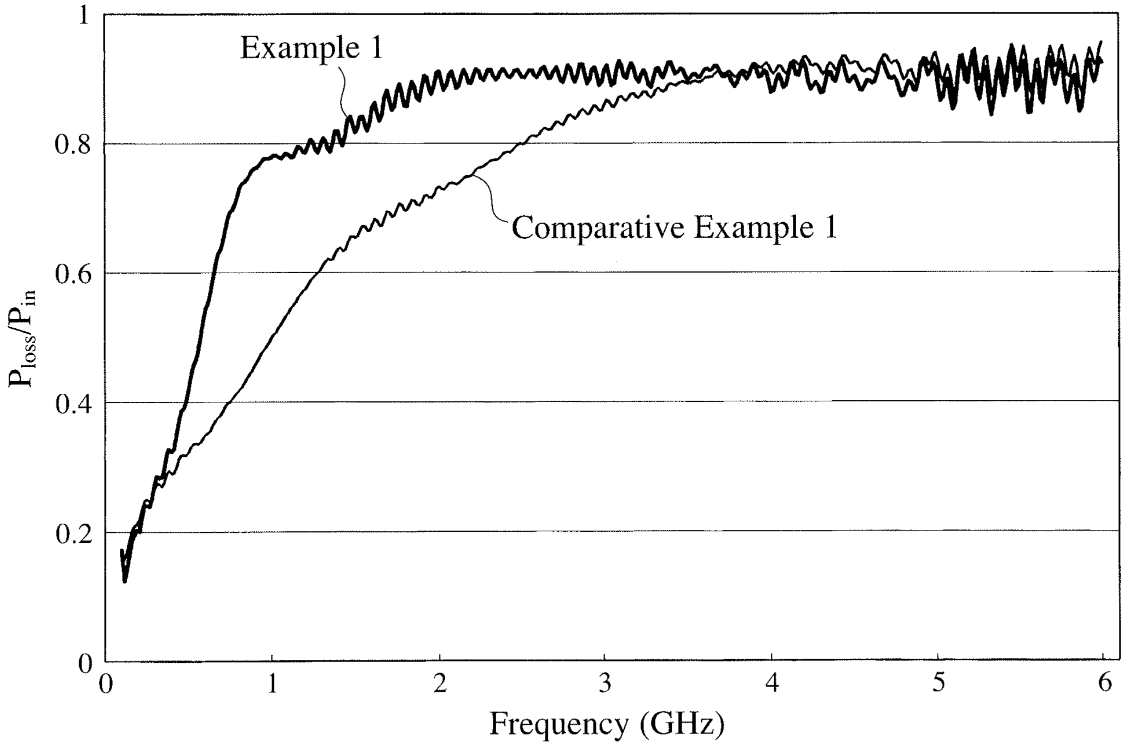

1
0.8
0.6
0.4
0.2
0
$P_{loss}/P_{in}$
Example 1
Comparative Example 1
0
1
2
3
4
5
6
Frequency (GHz)

Fig. 16

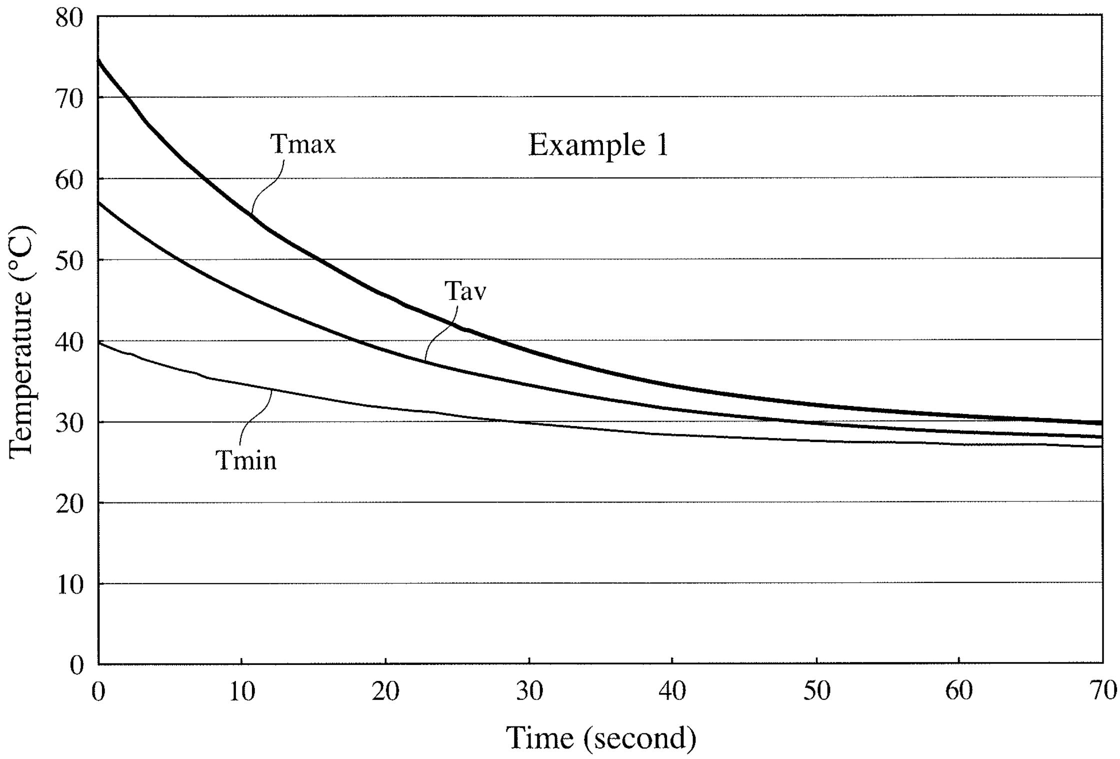
Example 1
Tmax
Tav
Tmin
Temperature (°C)
Time (second)
0
10
20
30
40
50
60
70
80

Fig. 17

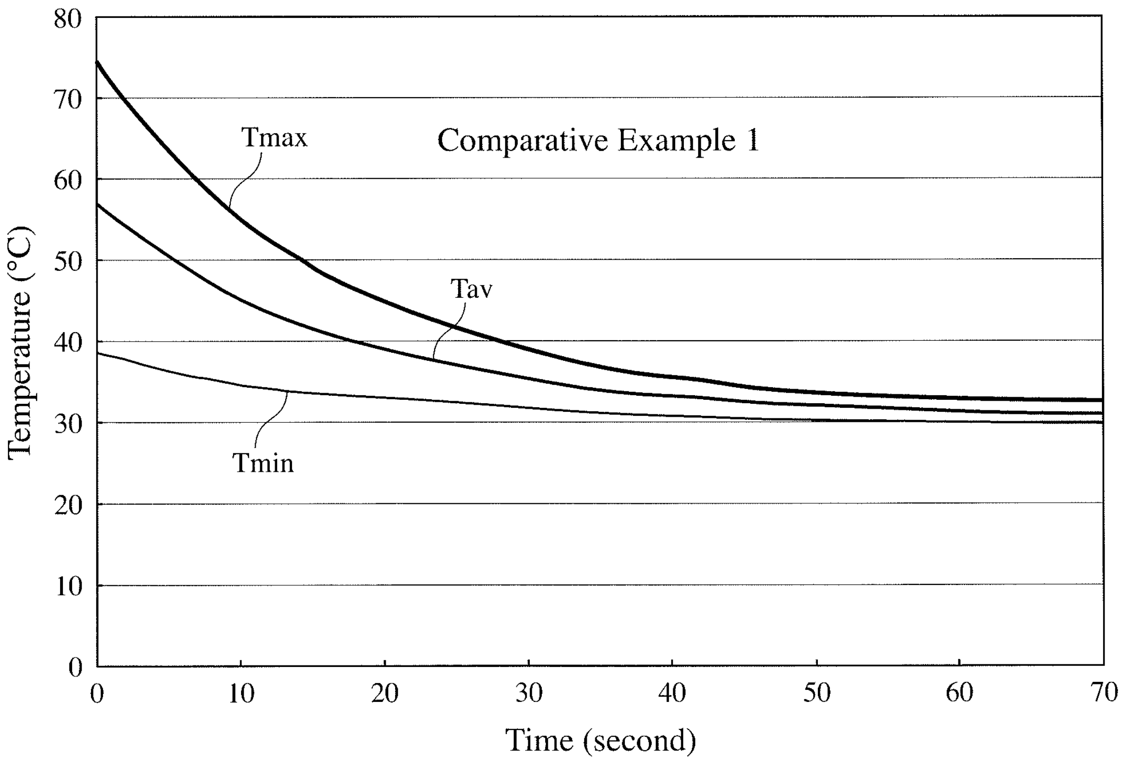
Comparative Example 1
Tmax
Tav
Tmin
Temperature (°C)
Time (second)
0
10
20
30
40
50
60
70
80

Fig. 18

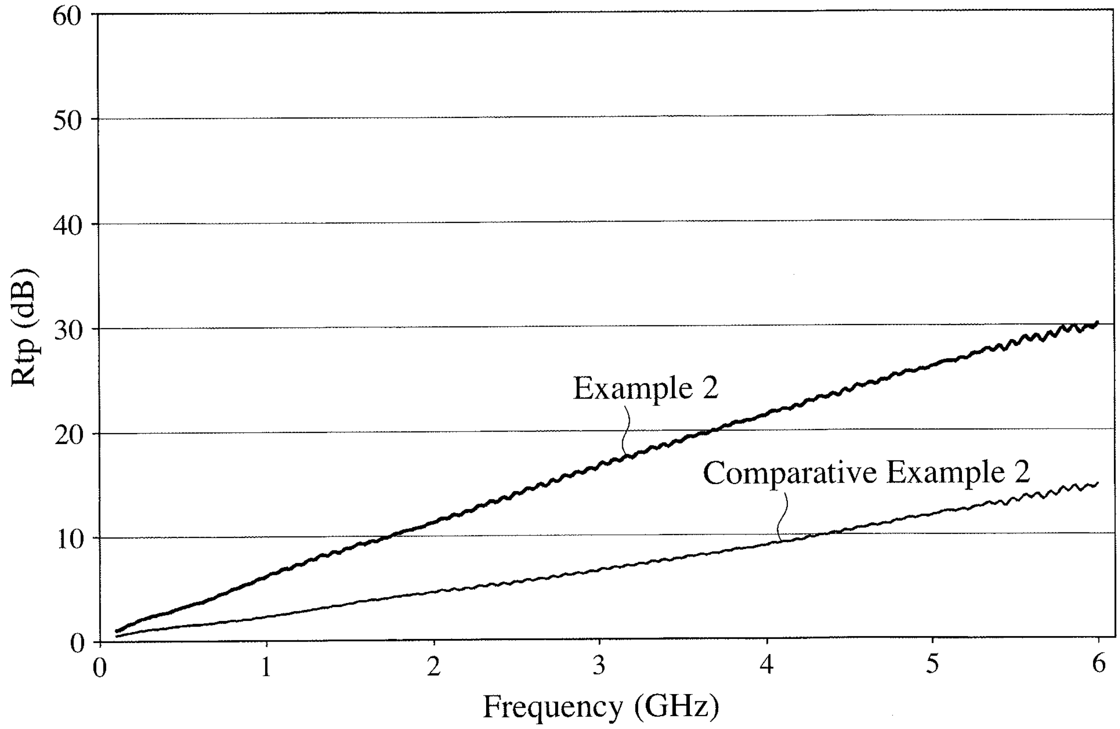
Rtp (dB)
60
50
40
30
20
10
0
Example 2
Comparative Example 2
0
1
2
3
4
5
6
Frequency (GHz)

Fig. 19

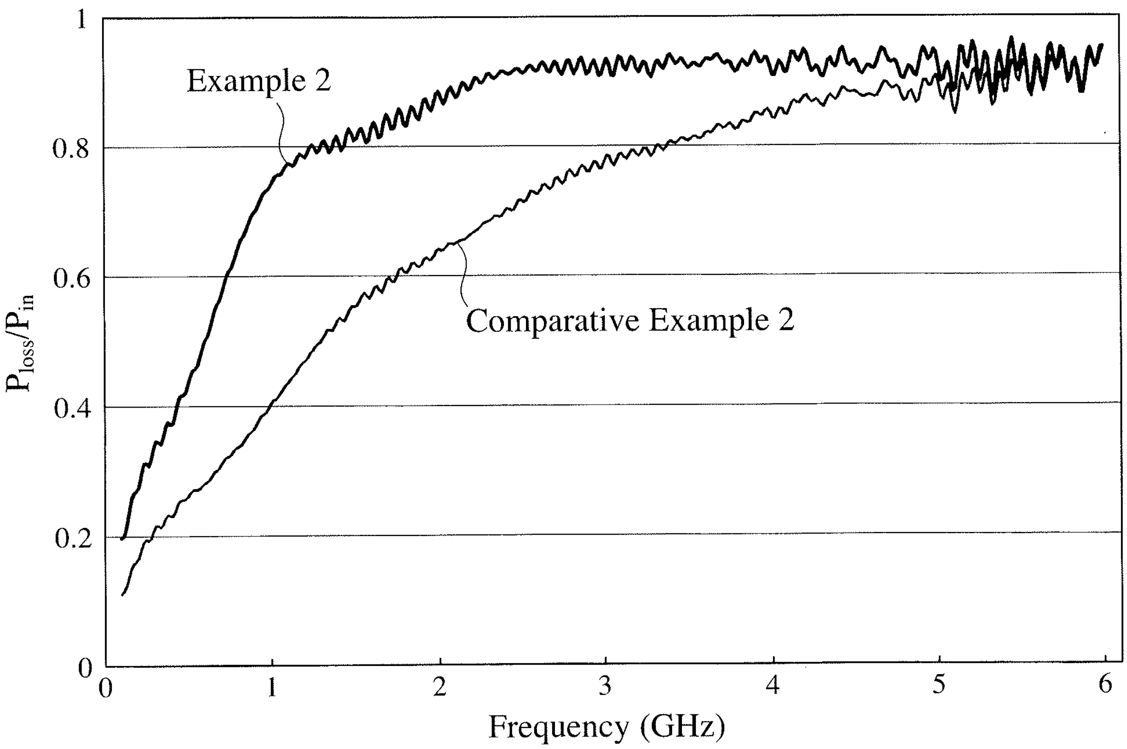
$P_{loss}/P_{in}$
1
0.8
0.6
0.4
0.2
0
Example 2
Comparative Example 2
0
1
2
3
4
5
6
Frequency (GHz)

# Fig. 20

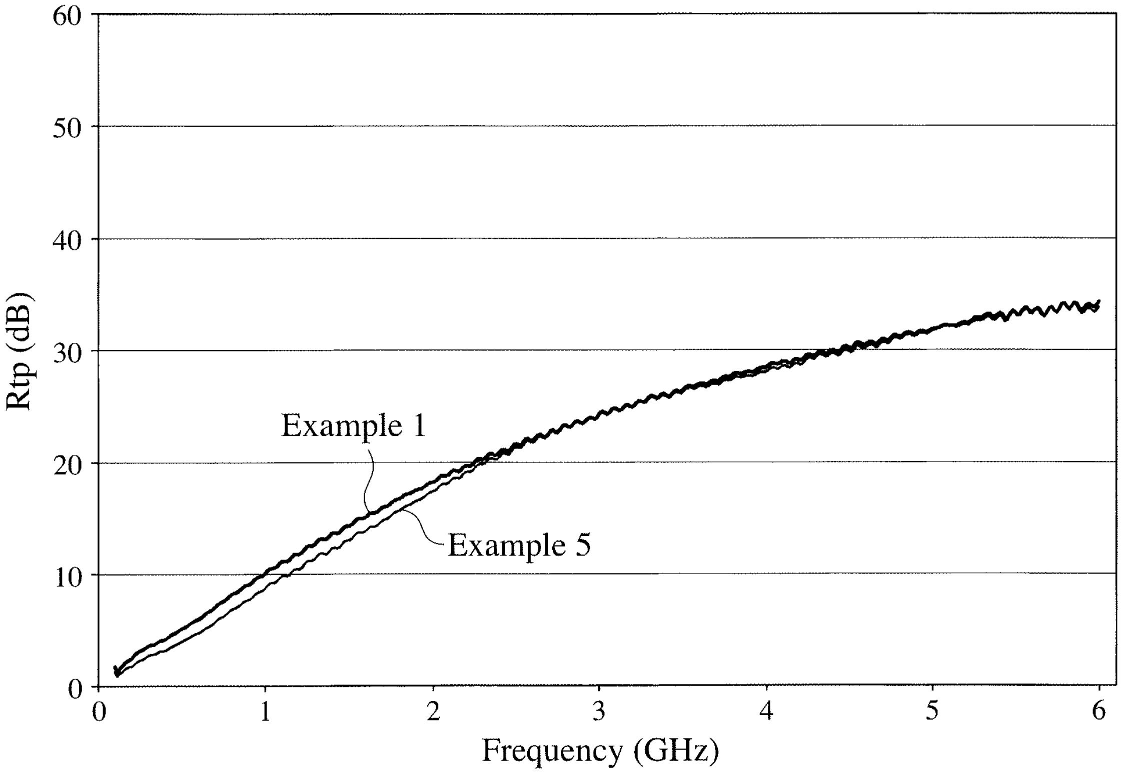
60
50
40
30
20
10
0
Rtp (dB)
Example 1
Example 5
0
1
2
3
4
5
6
Frequency (GHz)

# Fig. 21

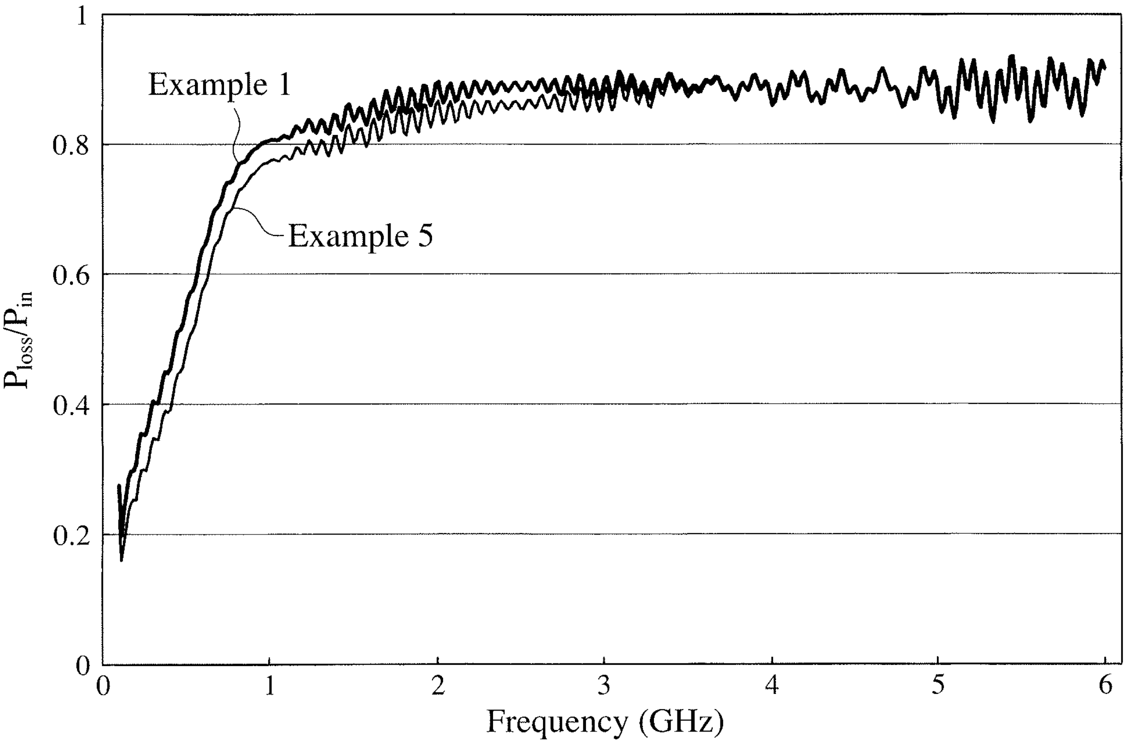
1
0.8
0.6
0.4
0.2
0
$P_{loss}/P_{in}$
Example 1
Example 5
0
1
2
3
4
5
6
Frequency (GHz)

Fig. 22

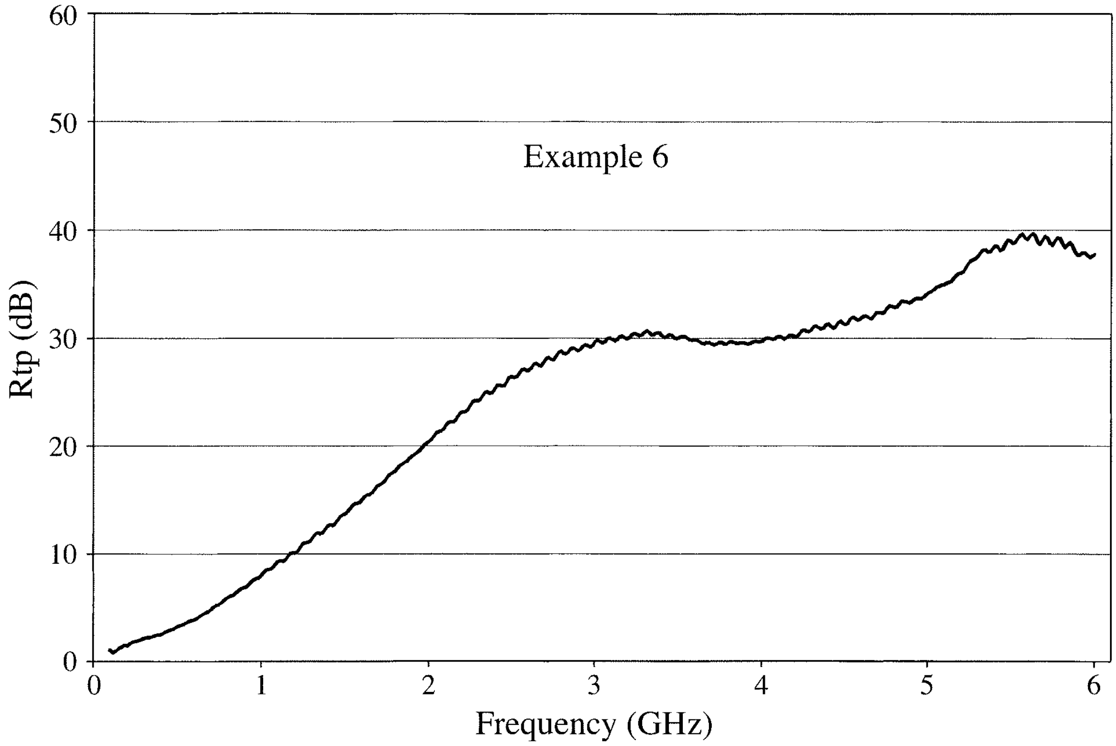
Example 6
Rtp (dB)
Frequency (GHz)
0
10
20
30
40
50
60
1
2
3
4
5
6

Fig. 23

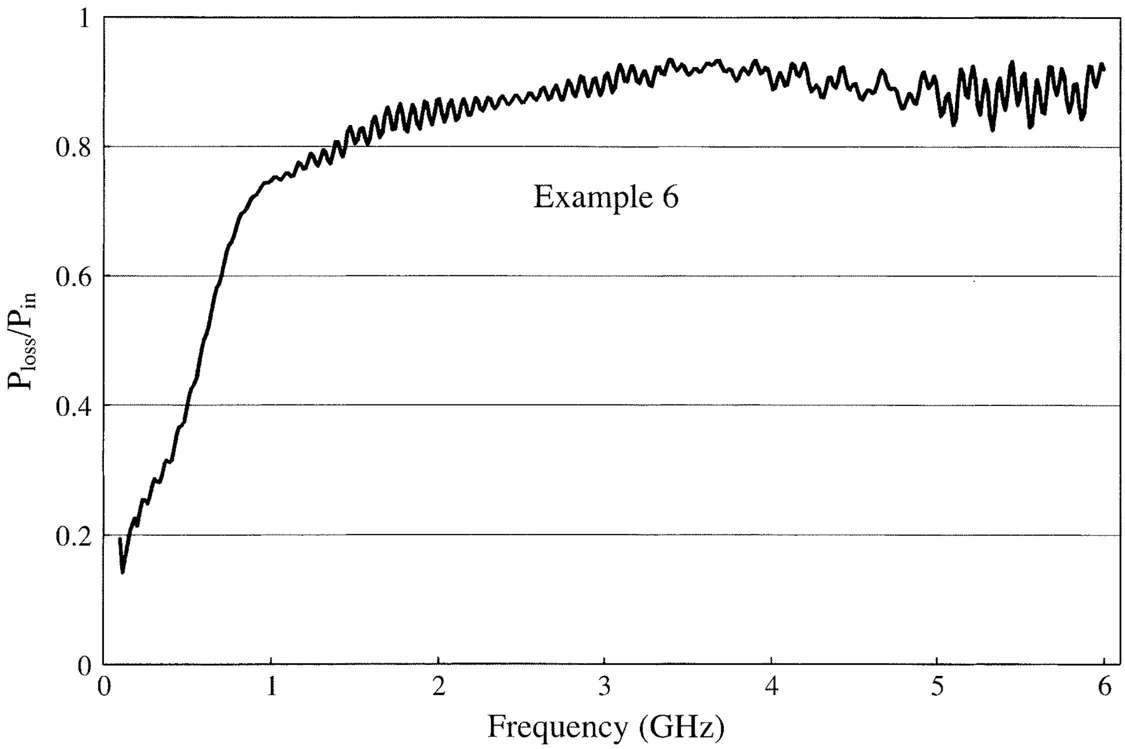
Example 6
$P_{loss}/P_{in}$
Frequency (GHz)
0
0.2
0.4
0.6
0.8
1
2
3
4
5
6

# Fig. 24

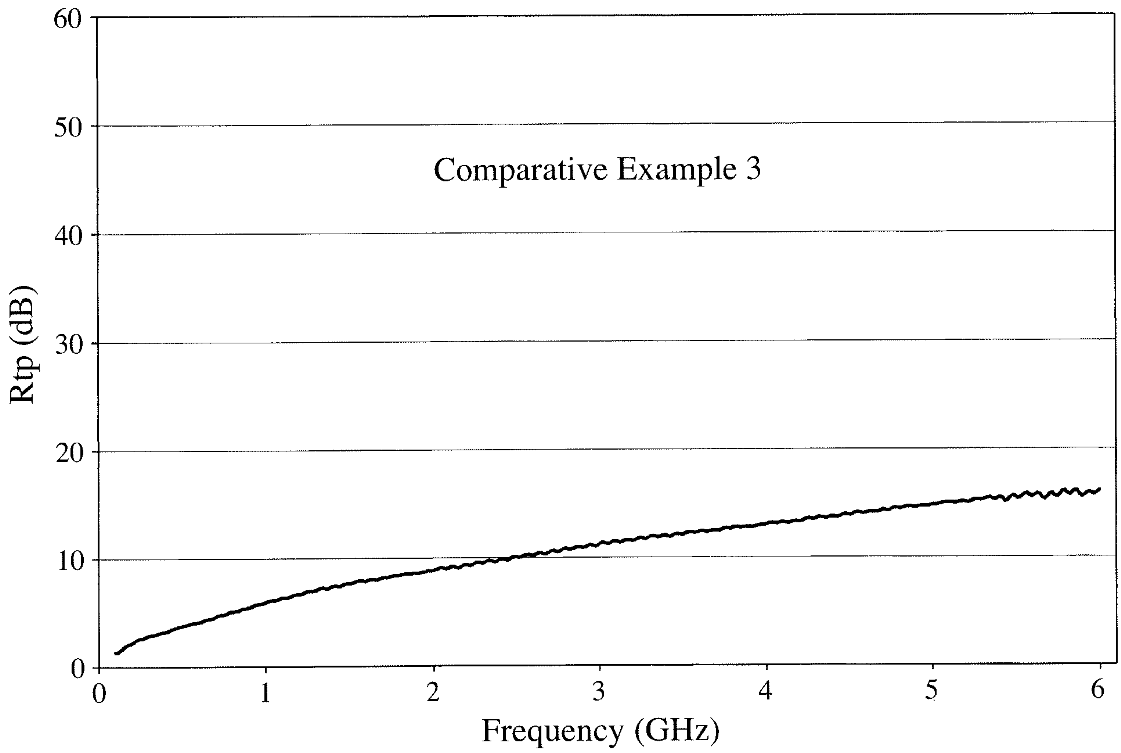
Rtp (dB)
60
50
40
30
20
10
0
Comparative Example 3
0
1
2
3
4
5
6
Frequency (GHz)

# Fig. 25

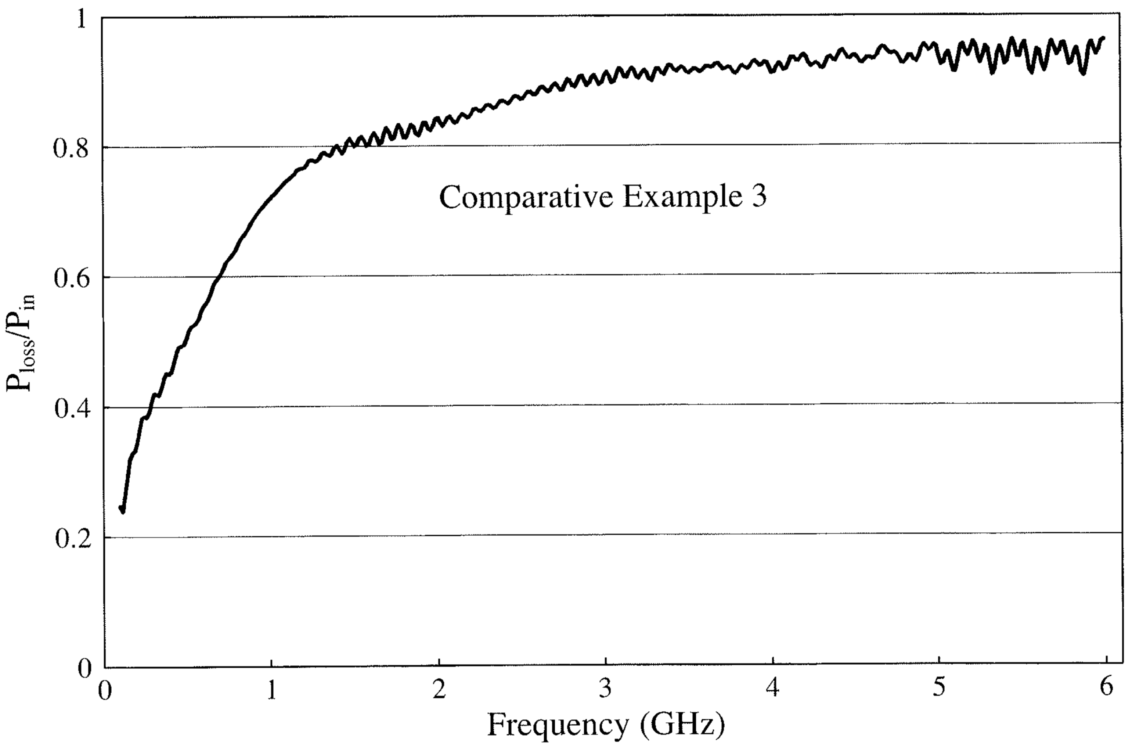
$P_{loss}/P_{in}$
1
0.8
0.6
0.4
0.2
0
Comparative Example 3
0
1
2
3
4
5
6
Frequency (GHz)

Fig. 26

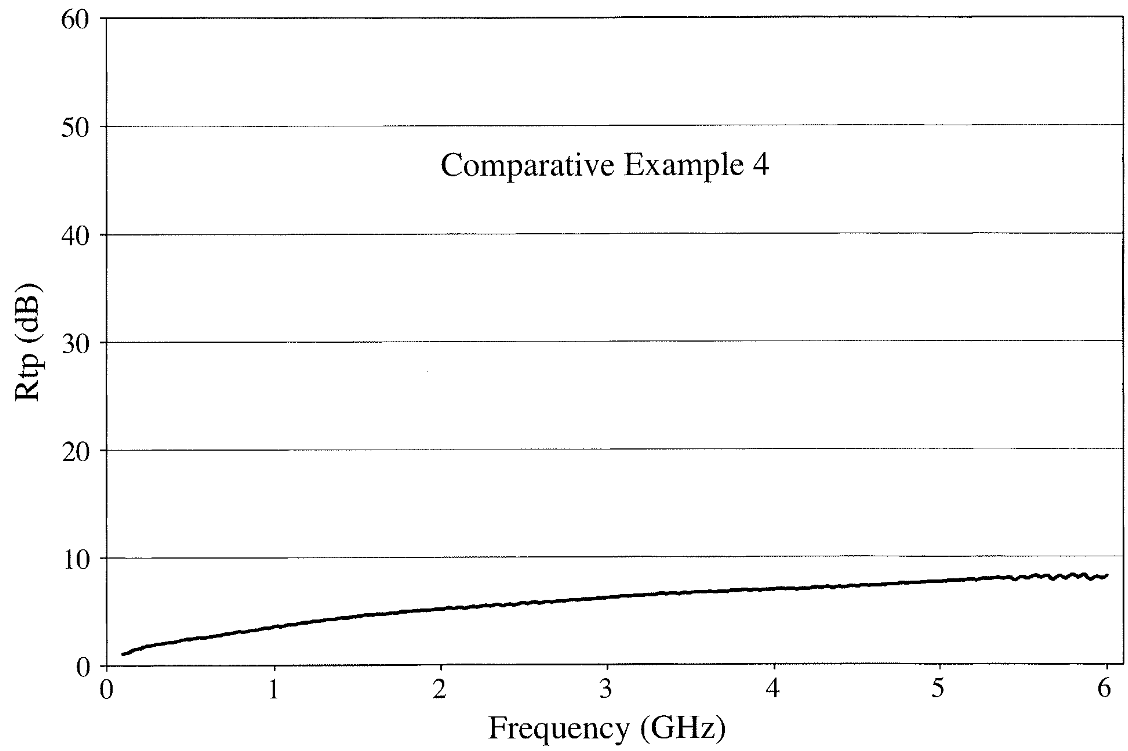
Rtp (dB)
60
50
40
30
20
10
0
Comparative Example 4
0
1
2
3
4
5
6
Frequency (GHz)

Fig. 27

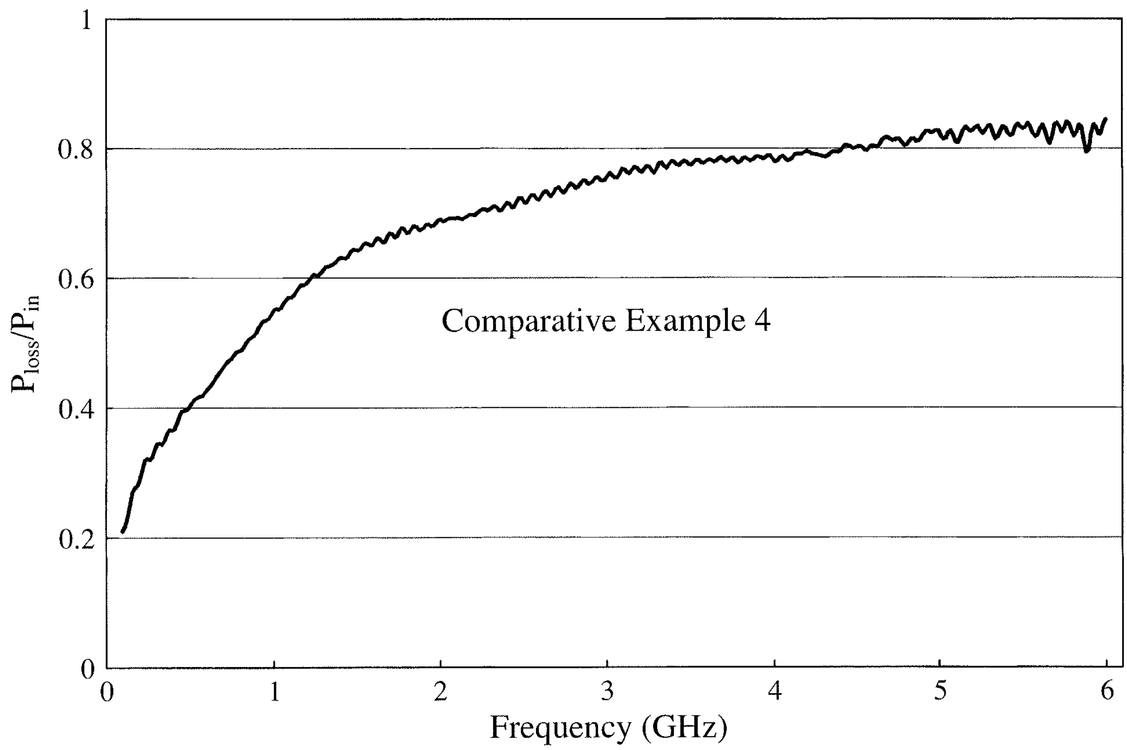
$P_{loss}/P_{in}$
1
0.8
0.6
0.4
0.2
0
Comparative Example 4
0
1
2
3
4
5
6
Frequency (GHz)

Fig. 28

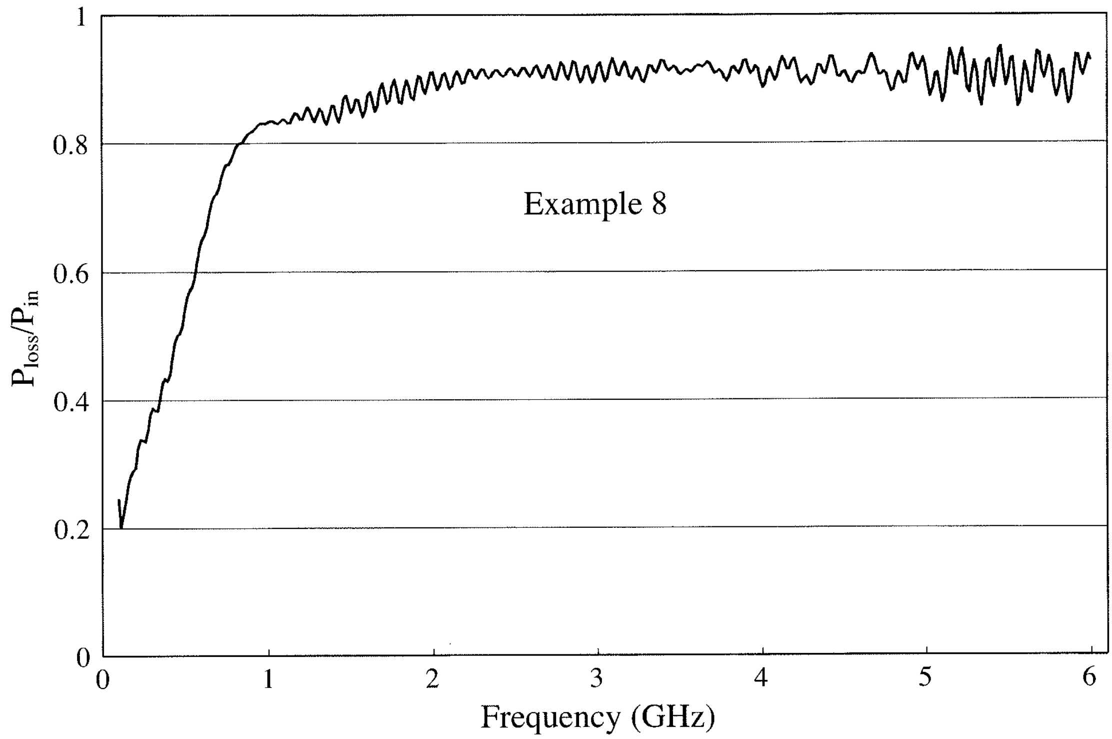
1
0.8
0.6
0.4
0.2
0
$P_{loss}/P_{in}$
Example 8
0
1
2
3
4
5
6
Frequency (GHz)

Fig. 29

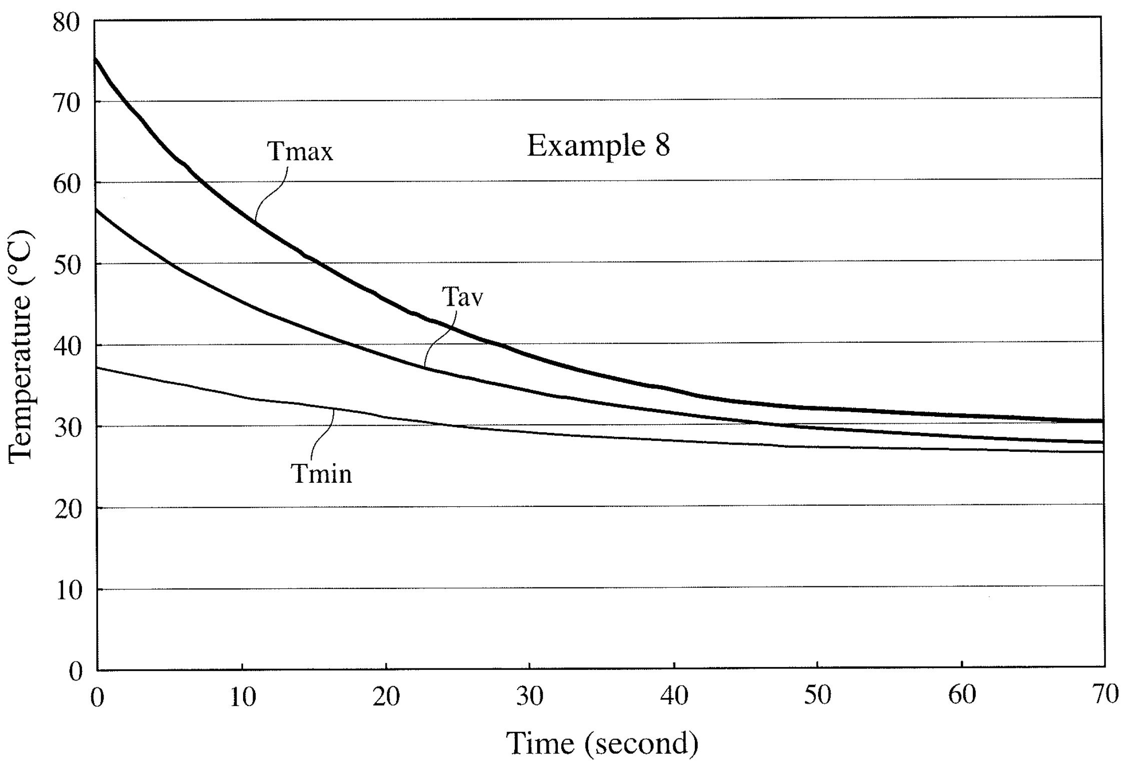
80
70
60
50
40
30
20
10
0
Temperature (°C)
Tmax
Example 8
Tav
Tmin
0
10
20
30
40
50
60
70
Time (second)

Fig. 30

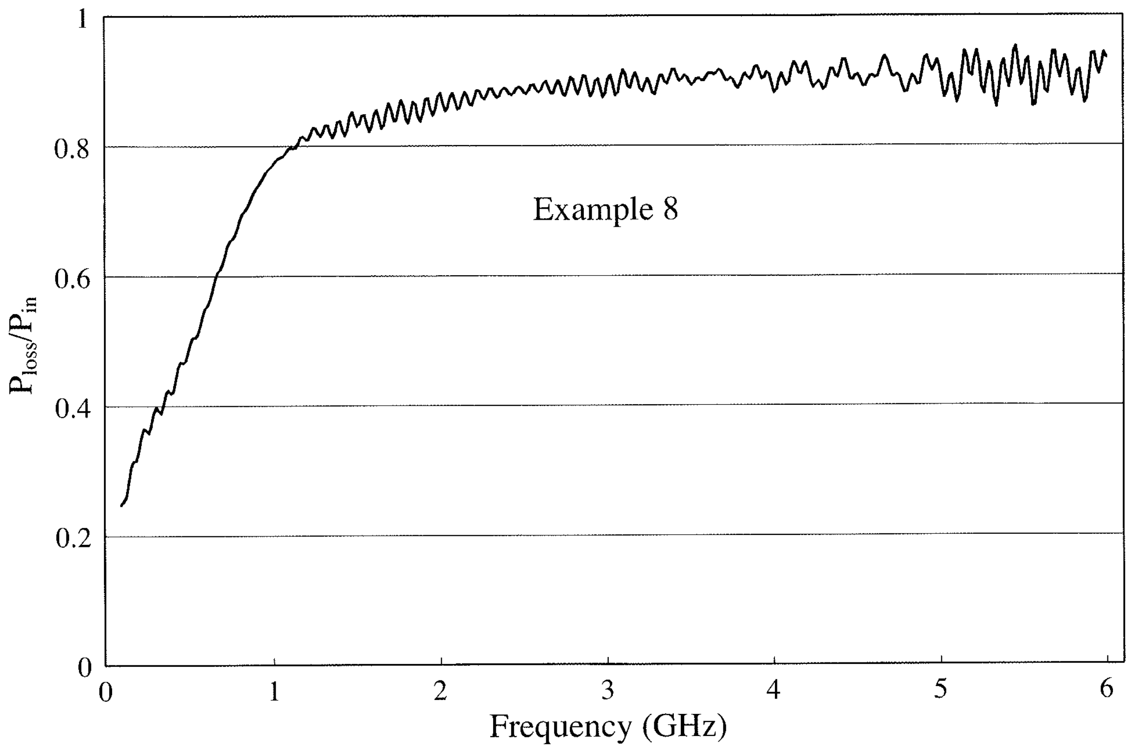
1
0.8
0.6
0.4
0.2
0
$P_{loss}/P_{in}$
Example 8
0
1
2
3
4
5
6
Frequency (GHz)

Fig. 31

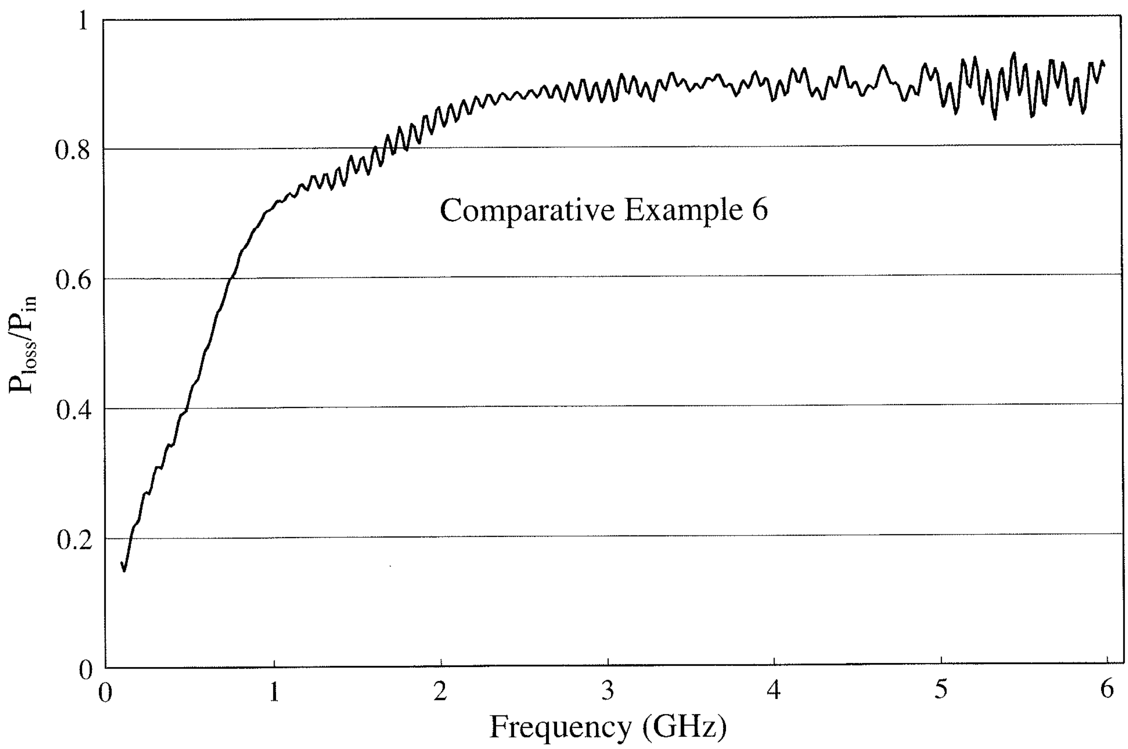
1
0.8
0.6
0.4
0.2
0
$P_{loss}/P_{in}$
Comparative Example 6
0
1
2
3
4
5
6
Frequency (GHz)

Fig. 32

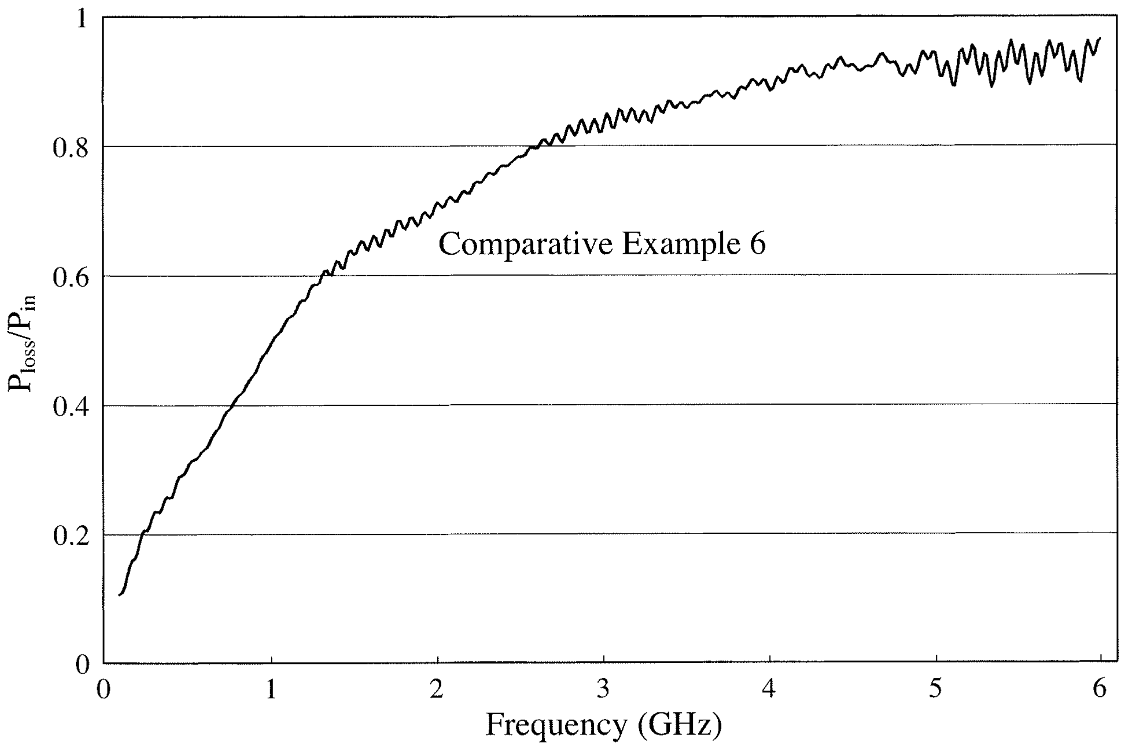
1
0.8
0.6
0.4
0.2
0
$P_{loss}/P_{in}$
Comparative Example 6
0
1
2
3
4
5
6
Frequency (GHz)

Fig. 33

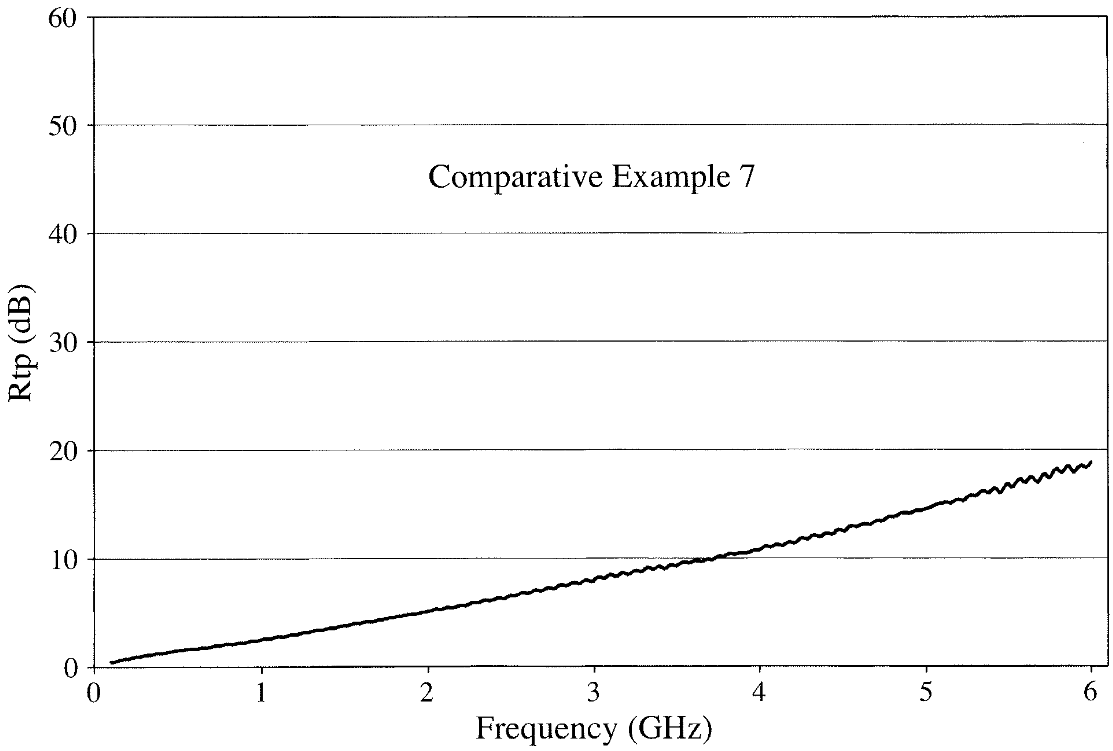
60
50
40
30
20
10
0
Rtp (dB)
Comparative Example 7
0
1
2
3
4
5
6
Frequency (GHz)

Fig. 34

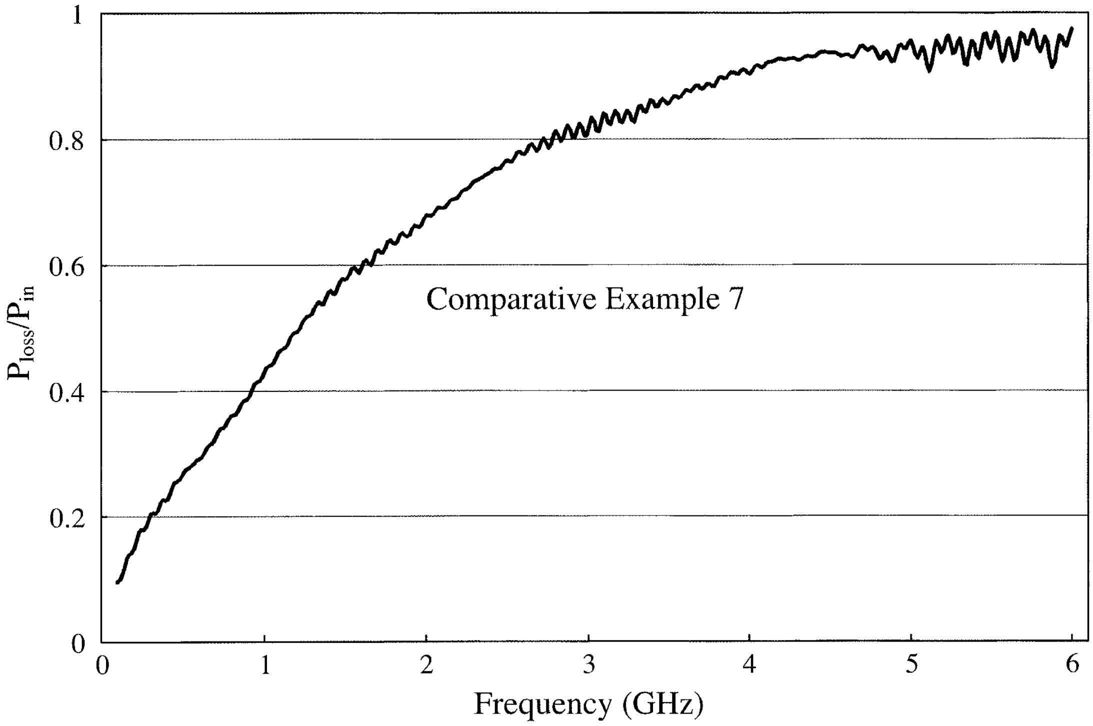
1
0.8
0.6
0.4
0.2
0
$P_{loss}/P_{in}$
Comparative Example 7
0
1
2
3
4
5
6
Frequency (GHz)

Fig. 35

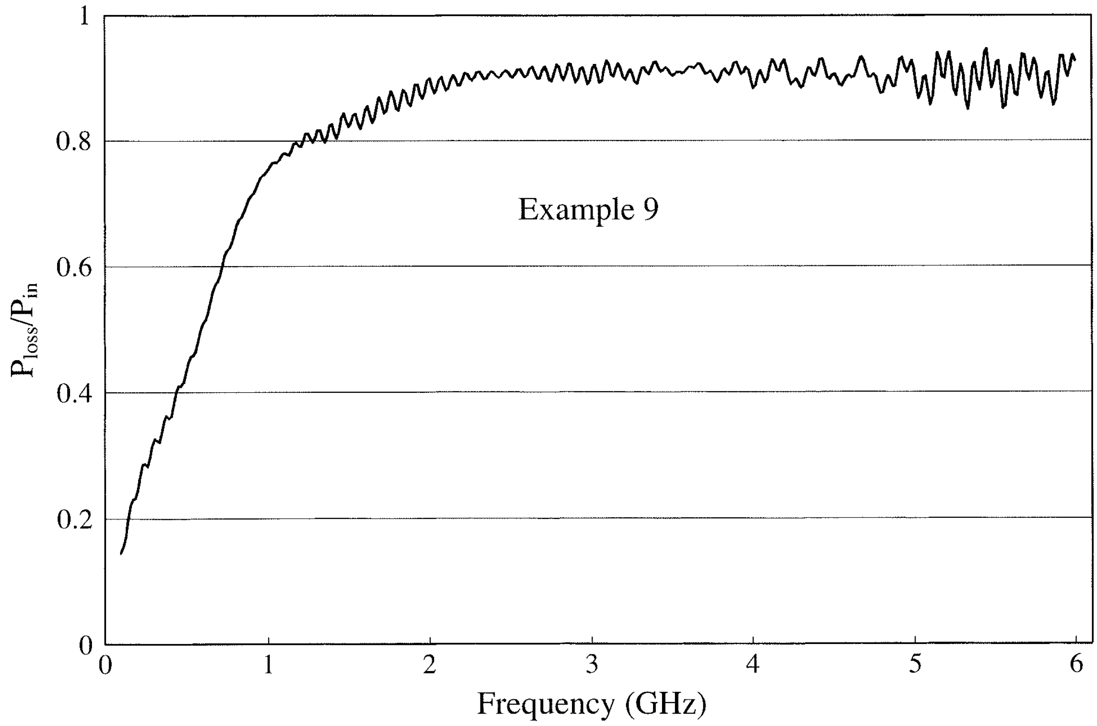
1
0.8
0.6
0.4
0.2
0
$P_{loss}/P_{in}$
Example 9
0
1
2
3
4
5
6
Frequency (GHz)

Fig. 36

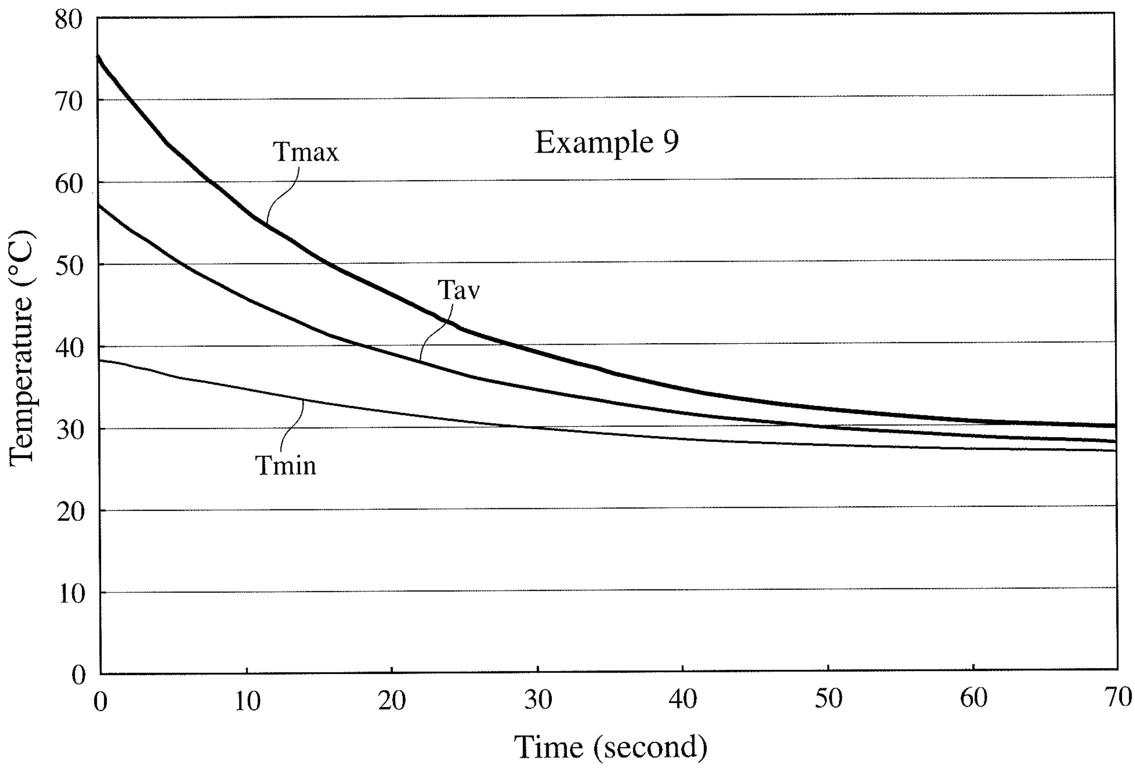
Example 9
Tmax
Tav
Tmin
Temperature (°C)
Time (second)
80
70
60
50
40
30
20
10
0
0
10
20
30
40
50
60
70

Fig. 37

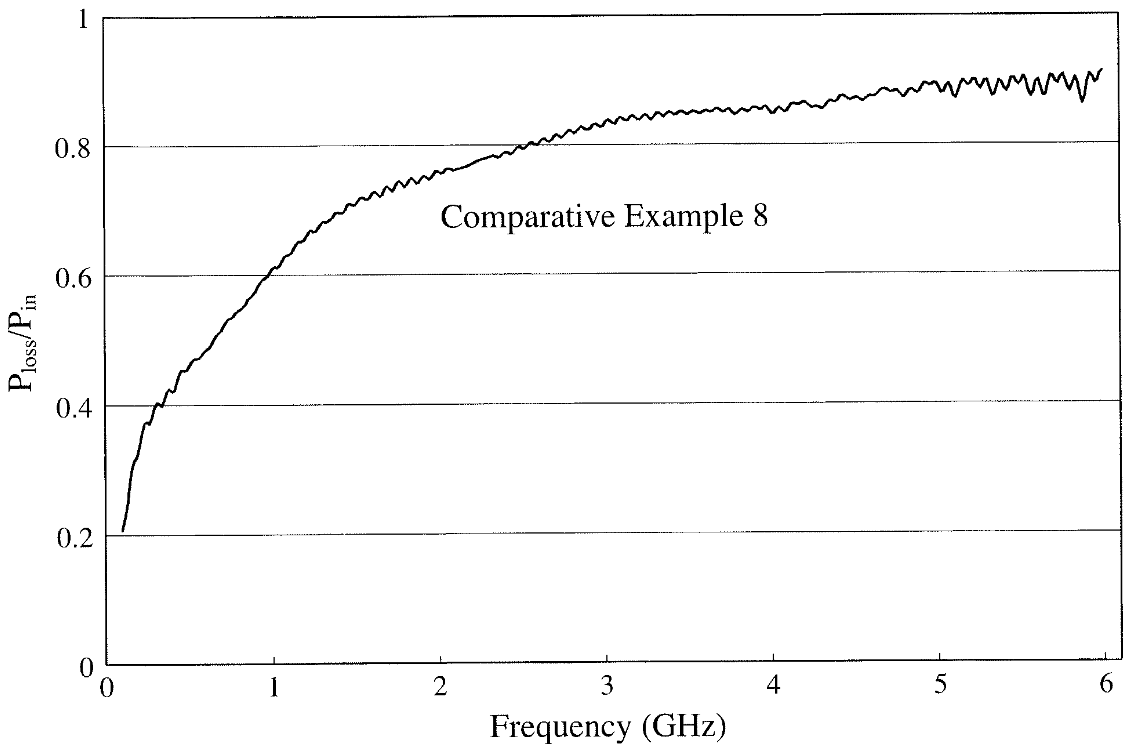
Comparative Example 8
$P_{loss}/P_{in}$
Frequency (GHz)
1
0.8
0.6
0.4
0.2
0
0
1
2
3
4
5
6

Fig. 38

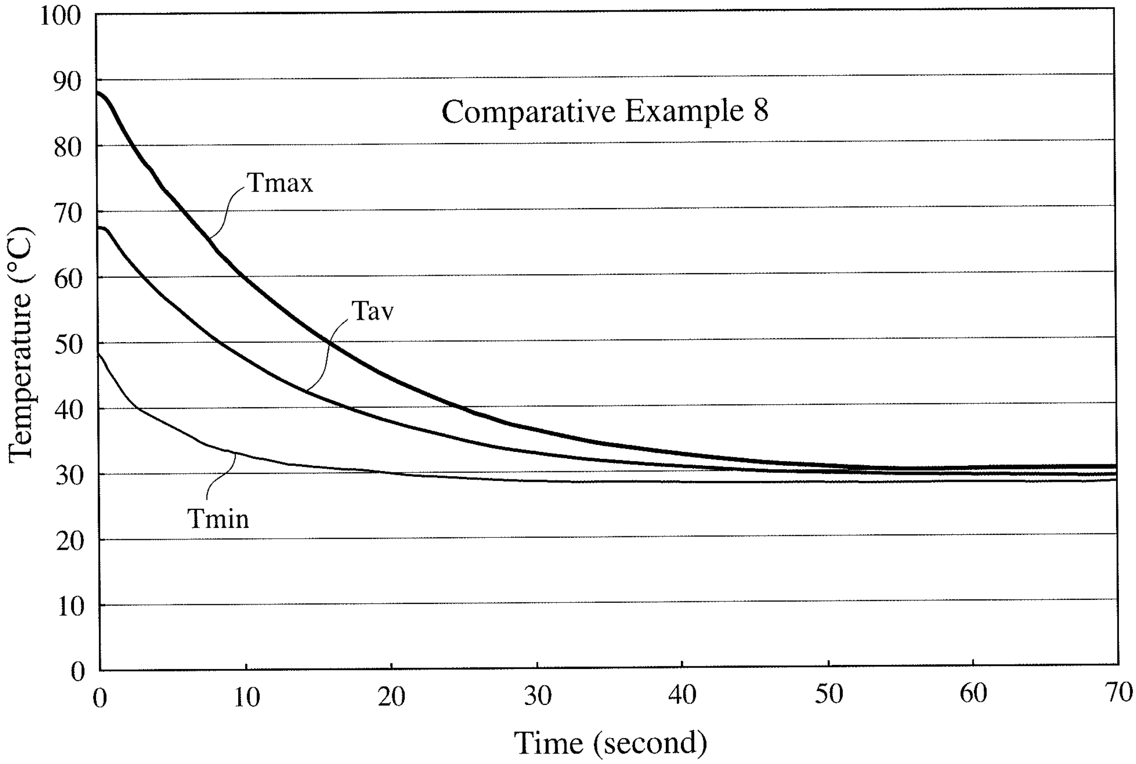
Comparative Example 8
Tmax
Tav
Tmin
Temperature (°C)
Time (second)
100
90
80
70
60
50
40
30
20
10
0
0
10
20
30
40
50
60
70

Fig. 39

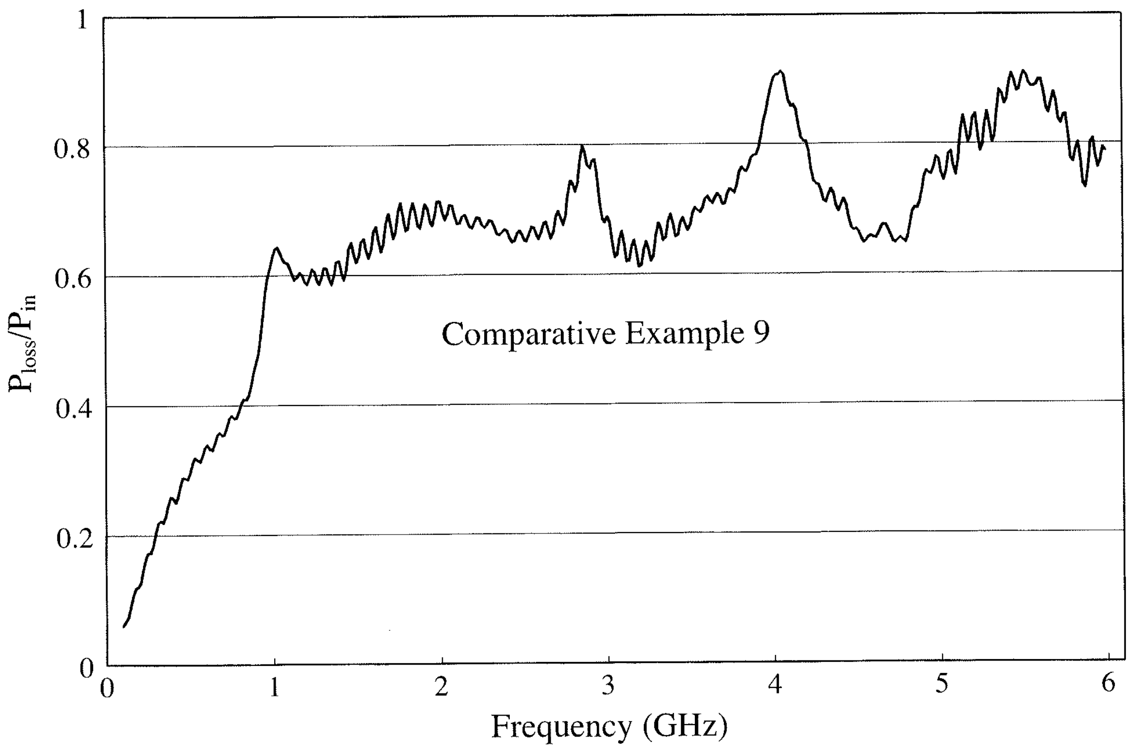
Comparative Example 9
$P_{loss}/P_{in}$
Frequency (GHz)
1
0.8
0.6
0.4
0.2
0
0
1
2
3
4
5
6

Fig. 40

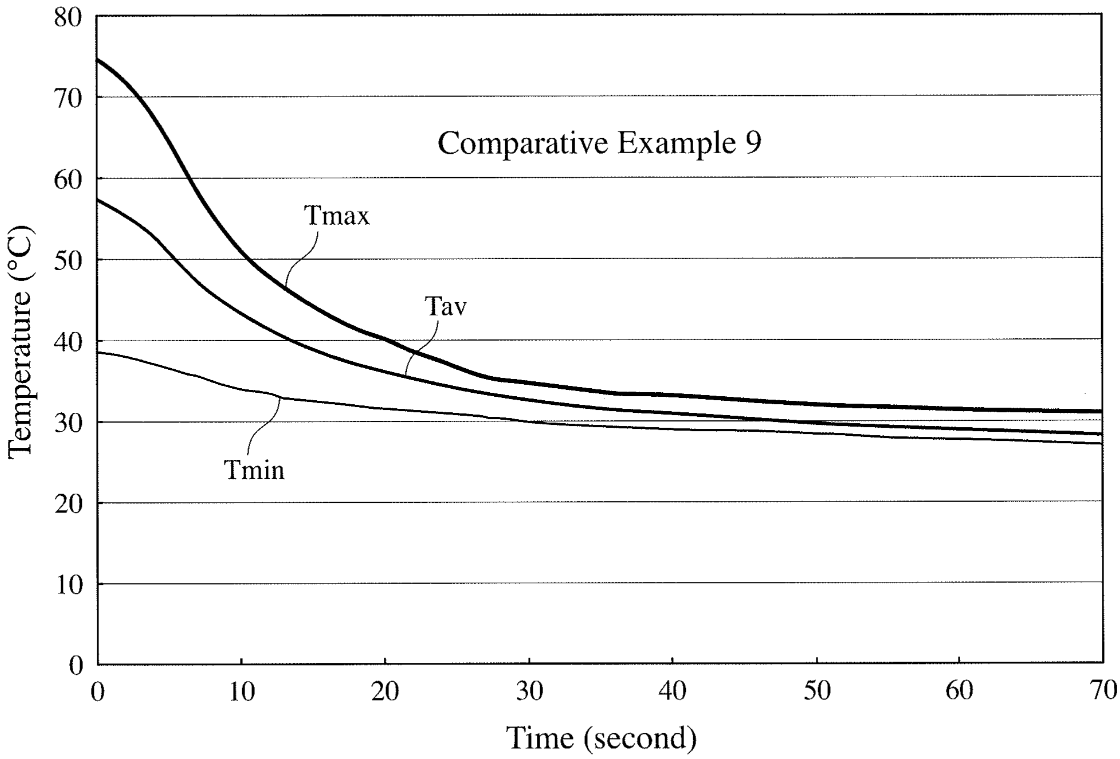
Comparative Example 9
Tmax
Tav
Tmin
Temperature (°C)
Time (second)
0
10
20
30
40
50
60
70
80

Fig. 41

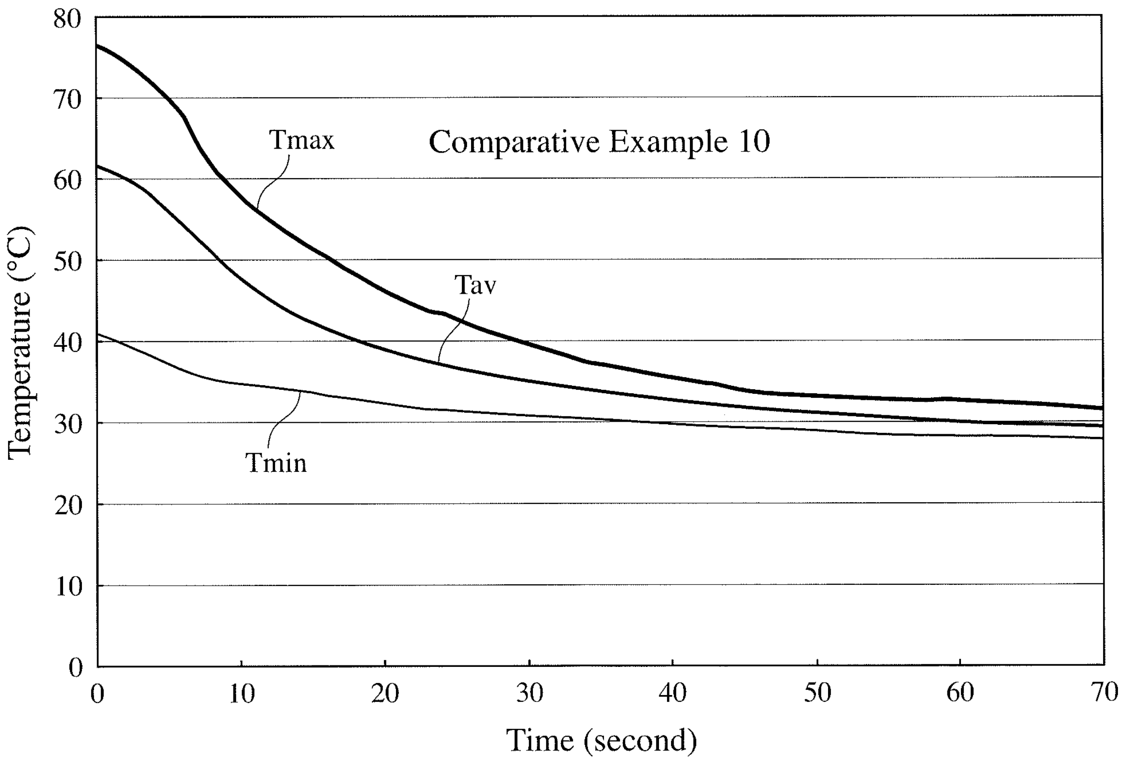
Comparative Example 10
Tmax
Tav
Tmin
Temperature (°C)
Time (second)
0
10
20
30
40
50
60
70
80

Fig. 42

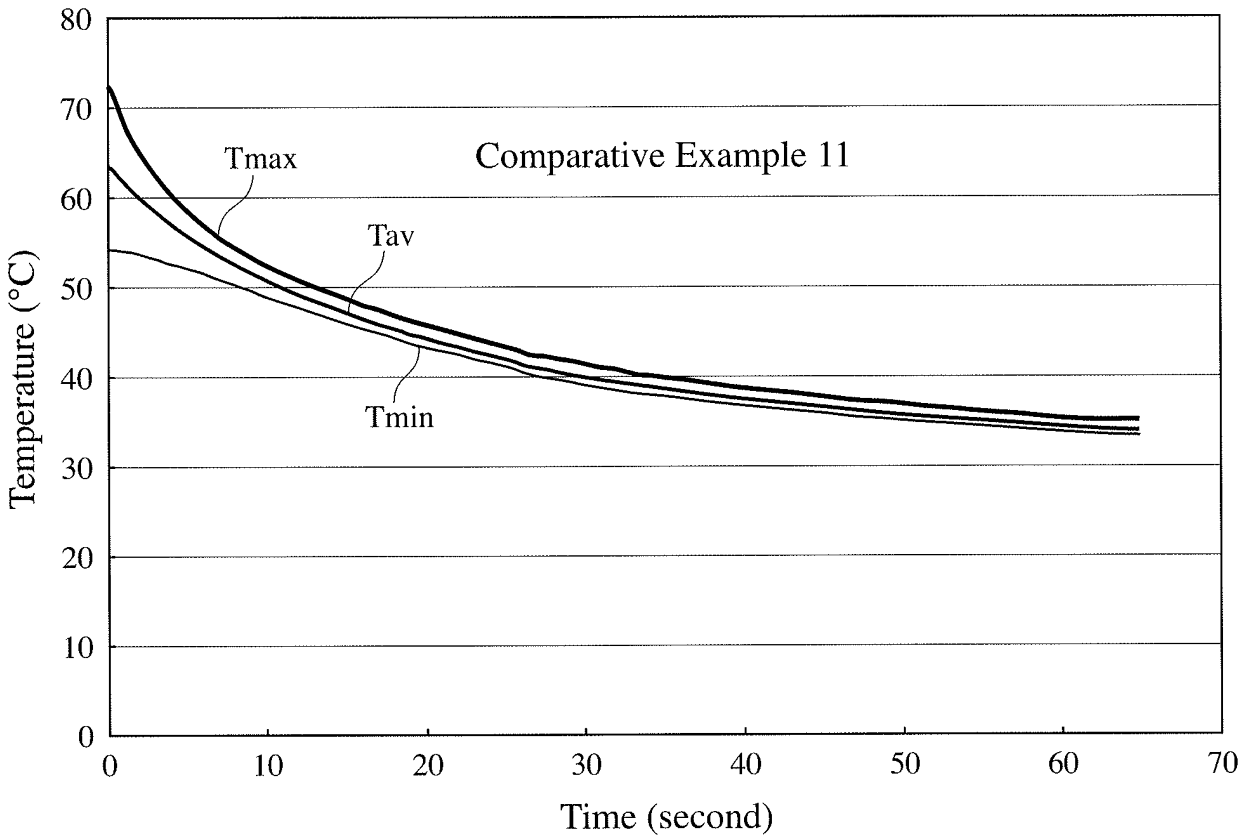
Comparative Example 11
Tmax
Tav
Tmin
Temperature (°C)
Time (second)
80
70
60
50
40
30
20
10
0
0
10
20
30
40
50
60
70

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 9148782 A
- JP 11040980 A
- WO 2010093027 A
- JP 2006135118 A
- US 20110008580 A1
- US 20050276978 A
- JP 2002059487 A
- JP 2063411 A